(19) Europäisches Patentamt
European Patent Office
Office européen des brevets

(11) EP 1 869 486 B1

(12) **EUROPÄISCHE PATENTSCHRIFT**

(45) Veröffentlichungstag und Bekanntmachung des Hinweises auf die Patenterteilung:
**13.05.2009 Patentblatt 2009/20**

(21) Anmeldenummer: **06723886.5**

(22) Anmeldetag: **31.03.2006**

(51) Int Cl.:
***G01R 33/46*** *(2006.01)*

(86) Internationale Anmeldenummer:
**PCT/EP2006/002923**

(87) Internationale Veröffentlichungsnummer:
**WO 2006/105909 (12.10.2006 Gazette 2006/41)**

(54) **VERFAHREN ZUR DATENAUFNAHME MULTIDIMENSIONALER NMR-SPEKTREN DURCH FREQUENZABHÄNGIGE FALTUNG**

METHOD FOR THE ACQUISITION OF MULTI-DIMENSIONAL NMR SPECTRA BY MEANS OF FREQUENCY-DEPENDENT FOLDING

PROCEDE D'ACQUISITION DE SPECTRES NMR MULTIDIMENSIONNELS A L'AIDE D'UN REPLIEMENT DEPENDANT DE LA FREQUENCE

(84) Benannte Vertragsstaaten:
**CH DE GB LI**

(30) Priorität: **08.04.2005 EP 05007767**

(43) Veröffentlichungstag der Anmeldung:
**26.12.2007 Patentblatt 2007/52**

(73) Patentinhaber: **Bruker BioSpin GmbH**
**76287 Rheinstetten (DE)**

(72) Erfinder: **SAKHAII, Peyman**
**65926 Frankfurt am Main (DE)**

(74) Vertreter: **Kohler Schmid Möbus et al**
**Patentanwälte**
**Ruppmannstrasse 27**
**70565 Stuttgart (DE)**

(56) Entgegenhaltungen:
**WO-A-20/04007016** **WO-A-20/04011909**

- **R.R. ERNST, G. BODENHAUSEN, A. WOKAUN: "Principles of NMR in One and Two Dimensions" 1992, CLARENDON PRESS , OXFORD , XP002361332 * siehe Seite 337, 2. Absatz ***

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Ein Problem in der Aufklärung der Struktur organischer oder anorganischer Verbindungen ist, dass multidimensionale NMR-Spektren in der Regel recht komplex sind, wobei größere Moleküle umso komplexere multidimensionale NMR-Spektren zeigen. Die Datenaufnahme (Acquisition) von Spektren mit akzeptabler Auflösung und die Interpretation solcher Spektren ist daher mit hohem Aufwand verbunden.

Standard-NMR-Verfahren sind beispielsweise das HSQC (Heteronuclear Single Quantum Coherence) oder das HMBC (Heteronuclear Multiple Bond Correlation), siehe IUPAC-Empfehlungen für NMR-Pulssequenzen (Angew. Chem. 2003, 115, 3293 - 3301). Reynolds und Enriquez beschreiben in J. Nat. Prod. 2002, 65, 221-244 NMR-Methoden zur Strukturaufklärung von Naturstoffen. Frydman (WO 2004/011899) beschreibt eine Methode zum Aufnehmen multidimensionaler NMR Spektren mit einem einzelnen Scan, wobei Partitionen einer Probe in einen Satz von unabhängigen Teilen mit unterschiedlichen Resonanzfrequenzbereichen unterteilt wird; und die Probe schichtweise (volumenabhängig) mit selektiven Pulsen (unter gleichzeitiger Anwendung von starken Gradienten-Pulsen) vermessen wird. Nachteil dieser Methode ist ihre geringe Empfindlichkeit und dass relativ große Probenmengen bzw. eine hohe Substanzkonzentration benötigt werden. Ein weiterer Nachteil dieser Methode ist, dass die Methode wegen der erforderlichen Summierung der Signale aus den unterschiedlichen Scans und der hohen Anforderungen an die Reproduzierbarkeit der Gradienten-Feldstärken schwer durchzuführen ist. K. Takasugi beschreibt eine Methode für die spektrale Rekonstruktion von gefalteten NMR-Spektren auf der Basis von multipler Faltung, wobei während der Datenaufnahme alle angeregten Frequenzen in der indirekten Dimension jeweils die gleiche Faltung erfahren, was einer frequenzunabhängigen Faltung entspricht (46th ENC Conference, 10.-15. April 2005, Providence, RI, USA; Zusammenfassung online verfügbar am 6. April 2005).

Dunn und Sidebottom (Magn. Reson. Chem. 2005, 43, 124-131) beschreiben eine Methode zur Rückrechnung von gefalteten NMR-Spektren mit dem Ziel der schnelleren Datenaufnahme und der Auswertung der strukturellen Konfirmation von kleinen organischen Molekülen, wobei während der Datenaufnahme 2 oder 3 NMR-Spektren mit verschiedenen reduzierten spektralen Fenstern in der indirekten Dimension gemessen werden.

Zweidimensionale (2D) I,S-Korrelationsexperimente bestehen aus einer Folge von Radiofrequenzpulsen und Delays, die den Transfer von Magnetisierung zwischen den Spins I und S bewirken. Die chemischen Verschiebungen der S-Kerne werden in einer indirekten (digitalisierten) Evolutionszeit t1 aufgenommen. Dabei wird das Delay, in dem die Evolution der chemischen Verschiebungen der S-Kerns stattfindet, schrittweise inkrementiert. Dies führt während t1 zu einer Modulation des NMR-Signals mit den Frequenzen der S-Kerne. Nach dem Magnetisierungstransfer wird die chemische Verschiebung der I-Kerne während t2 direkt detektiert. Fourier-Transformation entlang beider Zeitachsen führt zu einem 2D-Spektrum mit den chemischen Verschiebungen der S- und I-Spins als Achsen. Dieses Konzept lässt sich leicht durch die Einführung zusätzlicher indirekter Zeitdomänen auf mehr als zwei Dimensionen erweitern (M. Sattler in Angew. Chem. 2004, 116, 800-804). Ein zweidimensionales NMR-Experiment besteht aus mehreren Phasen, der ersten sogenannten Präparationsphase, einer zweiten sogenannten Evolutions- und Mischphase und der eigentlichen Detektionsphase, in der ein Interferogramm (FID) aufgezeichnet wird. Die Zeit der Evolutionsphase, t1 genannt, ist eine variable Wartezeit, die im Bereich von Millisekunden bis Sekunden liegt, innerhalb derer sich chemische Verschiebung und Spin-Spin-Kopplungen entwickeln. Nach der Evolutionsphase erfolgt die Mischphase mit der Zeit t2, die ebenfalls konstant ist. Die in einem zweidimensionalen NMR-Experiment aufgezeichneten Daten werden oft im sogenannten Konturdiagramm dargestellt. Ein solches Konturdiagramm zeigt einen Schnitt entlang einer Höhenlinie durch die Kreuzsignale des Spektrums. Diese zweidimensionalen Experimente können auch als Bestandteil mehrdimensionaler Experimente durchgeführt werden.

Das Standardverfahren zur Datenaufnahme eines multidimensionalen NMR-Spektrums beruht auf der Anwendung einer bestimmten Sequenz und Abfolge von Anregungspulsen hoher Frequenz (Pulses) und Wartezeiten (Delays). Die dabei entstehenden Kohärenzordnungen von Magnetisierungen, ihr Transfer in andere Kohärenzen und die Regeln zur Auswahl der gewünschten Magnetisierungen wird vollständig durch den Product Operator Formalismus beschrieben.

NMR-Experimente, in denen die Frequenzen in der indirekten Evolutionsphasen nicht gefaltet wurden, werden im folgenden gleichbedeutend als "normale NMR-Experimente", "konventionelle NMR-Experimente" oder "Standard-NMR-Experimente" bezeichnet. Konventionelle multidimensionale NMR-Spektren sind beispielsweise homo- und heteronuklearen multi-dimensionalen NMR-Experimente wie HSQC (J. Am. Chem. Soc. 1992, 114, 10663-10665), HMBC, COSY, TOCSY, HSQC-TOCSY, insbesondere 2- und 3-dimensionale NMR-Experimente. Die Dimension der multidimensionalen NMR-Experimente ist beispielsweise bei zweidimensionalen heteronuklearen NMR-Experimenten die Dimension der chemischen Verschiebung der Protonen und die Dimension der chemischen Verschiebung der betrachteten Heterokerne, z.B. der Kohlenstoffatome.

Bei der konventionellen Methode zur Datenaufnahme eines multidimensionalen NMR-Spektrums, wird im Allgemeinen in der Evolutionsphase die Evolutionszeit linear inkrementiert, wobei die Inkrementierungszeit $\Delta t1$ in der Evolutionsphase das Nyquist-Theorem (Gleichung 1) erfüllt, um das korrekte spektrale Fenster in der indirekten Dimension zu liefern.

Gleichung 1: $IN0 = 1/(Nd0 \times BF1 \times SW1)$,

wobei

d0 = initial delay (initiale Wartezeit),
Nd0 = Anzahl von $\Delta t1$ Inkrementen,
SW1 = Spektrales Fenster in der indirekten Dimension,
BF1 = Basisfrequenz (z.B. bei 9.39 T für $^{1}H$ 400.13 Hz und für $^{13}C$ 100.58 Hz),
IN0 = Inkrementierungszeit

Bei der Realisierung der oben beschriebenen experimentellen Bedingungen unter Einhaltung des Nyquist-Theorems zur korrekten Digitalisierung der Frequenzen erhält man nach der Fouriertransformation (FT) in beiden Dimensionen (Gleichung 2) die Kreuzsignale in der Frequenzdomäne, wobei die chemische Verschiebung der gemessenen Kreuzsignale in der indirekten Dimension korrekt, d.h. nicht gefaltet wiedergegeben sind.

Gleichung 2: $S(t1, t2) \rightarrow FT \rightarrow S(\nu 1, \nu 2)$,

wobei

S(t1, t2) = Signal nach Inkrementierungszeit
$S(\nu 1, \nu 2)$ = Fouriertransformiertes Signal

Aus der Gleichung 1 ist zu entnehmen, dass das indirekte spektrale Fenster SW1 in umgekehrter Proportion zur Inkrementierungszeit IN0(=$\Delta$t1) steht. Dies hat zur Folge, dass bei einer Verlängerung von $\Delta$t1 das indirekte spektrale Fenster SW1 verkleinert wird und als Konsequenz daraus die Frequenzen derjenigen Kreuzsignale eines multidimensionalen NMR-Spektrums, die außerhalb des gewählten spektralen Fensters liegen, nicht mehr korrekt digitalisiert werden und somit nicht an der ursprünglichen chemischen Verschiebung im NMR-Spektrum auftreten. Dieses Phänomen der Faltung in der Datenaufnahme von NMR-Spektren ist in der Literatur (Two-Dimensional NMR spectroscopy, 2nd ed. 1994, W.R. Croasmun und R.M.K. Carlson, Wiley-VCH, Seite 493-503) ausführlich beschrieben und führt generell zur Verkürzung der Gesamt-Messzeit und zur Erhöhung der digitalen Auflösung der Kreuzsignale, was sich aus den Gleichungen 3-5 ergibt:

Gleichung 3: $DR = SW [Hz] / TD1^*$,

wobei

SW [Hz] = Spektrales Fenster in Hertz
DR= Digitale Auflösung,
TD1*= Komplexnummer des Experiments (complex number of experiments)

Gleichung 4: $DR = 1 / AQ(t1)$

AQ(t1) = Acquisitionszeit in der indirekten Dimension nach Gleichung 5.

Gleichung 5: $AQ(t1) = Nd0 \times IN0 \times TD1^*$.

Für die chemischen Verschiebungen (in diesem Zusammenhang "Frequenzen" oder "apparent frequency" vi genannt) der Kreuzsignale in der indirekten Dimension aller angeregten und in der Evolutionszeit befindlichen Kohärenzen und unabhängig von einer möglichen Verletzung des Nyquist-Theorems gilt laut Gleichung 6 eine direkte funktionale Abhängigkeit von der $\Delta t1$-Inkrementierungszeit.

Gleichung 6:
$$\nu_i(\Omega s) = f\,(\Delta t1)$$
$$\nu_{i+1}(\Omega s) = f\,(\Delta t1),$$

wobei

$\nu_i(\Omega s)$, $\nu_{i+1}(\Omega s)$ = chemische Verschiebung des Kreuzpeaks i bzw. i+1,
$f\,(\Delta t1)$ = Funktion der Inkrementierungszeit $\Delta t1$.

Die Analyse der Kreuzsignale (cross peaks) eines multidimensionalen NMR-Spektrums z.B. eines HSQC-Spektrums zeigt bei genauerer Betrachtung der Resonanzfrequenzen, dass sich die Kreuzsignale abhängig von Ihrer chemischen Verschiebung in vorzugsweise übereinanderliegenden Signalgruppen (Peak cluster) im Frequenzraum anordnen. Als Konsequenz davon, gibt es Frequenzbereiche in dem multidimensionalen NMR-Spektrum, die in der Regel keine Kreuzsignale und damit keine Informationen beinhalten.

Diese Beobachtung wird erhärtet, wenn man sich vergegenwärtigt, dass beispielsweise in erster Näherung die elektronenarmen aromatischen Protonen (Tieffeld-verschobene Signalbereiche) stets mit Kohlenstoffen im Tieffeld-verschobenen Bereichen in einem HSQC-NMR-Spektrum Kreuzsignale ergeben. Da jedoch in der Routinemessung aus Gründen der Einhaltung des Nyquist-Theorems über den gesamten gewünschten chemischen Verschiebungsbereich gemessen wird, gibt es zwangsläufig leere Frequenzräume, die keine oder geringe Anzahl von Signalen beinhalten. Ein konventionelles HSQC-Spektrum von einem organischen Molekül einer Molmasse zwischen 300 und 500 g/mol ergibt in der Regel ein NMR-Spektrum, in dem mehr als 95% der Frequenzbereiche keinerlei Informationen in Form von Kreuzsignalen beinhalten. Bei kleinen Molekülen bleibt schätzungsweise bis zu 99% des Frequenzraums ungenutzt.

In der NMR-Spektroskopie gibt es ferner verschiedene Arten von Radiofrequenzpulsen, sogenannte RF pulses. Die "hard pulses" sind rechteckige Pulse mit weiter Anregungsbandbreite (rectangular high power pulses with a wide frequency excitation band), Die "hard pulses" sind unselektiv. "Shaped pulses" sind Pulse, die selektiv bestimmte Frequenzbereiche anregen. Solche Pulse sind beispielsweise Gauß-, Rectangular-, Sine-, BURP-Pulse, und werden im folgenden zusammenfassend shape pulses oder selektive Pulse genannt (amplitude and power shaped pulses with a selective excitation band), siehe beispielsweise Freeman, Journal of Progress in Nuclear Magnetic Resonance Spectroscopy 1998, 32, 59-106.

Die WO 2004/007016 A2 beschreibt ein Verfahren der G-Matrix Fouriertransformations-NMR zur schnellen Zurordnung von chemischer Verschiebung und Sekundärstrukturbestimmung bei Proteinen. Dabei wird ein phasenempfindliches gemeinsames Samplen von mehreren indirekten Dimensionen vorgenommen.

Die vorliegende Erfindung stellt ein Verfahren zur Verfügung, mit dem Anhäufungen von Signalgruppen, auch "Cluster" genannt, bestehend aus mehreren Kreuzsignalen eines multidimensionalen NMR-Spektrums selektiv und abhängig von ihrer Frequenz (band selective folding) so gefaltet werden, dass die Koordinaten der Signale (ausgedrückt durch ihre "apparent frequency") im gefalteten NMR-Spektrum einzelner Cluster oder Clustergruppen in einem bisher nicht von anderen Signalen besetzten Bereich des Spektrums verteilt werden, vorteilhafterweise über den gesamten vorhandenen Frequenzraum.

Mit dem Verfahren ist es möglich, Kreuzsignale an beliebigen Positionen im Frequenzraum zu verlagern, was erhebliche Auswirkung auf die Reduzierung der Gesamtmesszeit eines NMR-Experimentes, höhere Auflösung des NMR-Spektrums und bessere Auswertbarkeit der resultierenden multidimensionalen NMR-Spektren hat. Alle Kreuzsignale eines mehrdimensionalen NMR-Spektrums werden durch das erfindungsgemäße Verfahren mittels frequenzabhängiger Faltung verlagert. Insbesondere von Nutzen ist es, solche Kreuzsignale zu verlagern, die eine starke Überlappung mit anderen Kreuzsignalen ausweisen.

Das erfindungsgemäße Verfahren beschreibt demnach ein Verfahren zur Datenaufnahme in der multidimensionalen NMR-Spektroskopie. Das SHARC-Protocol genannte Verfahren (SHaped ARrayed data aCquisition Protocol) nutzt die Eigenschaften von selektiven Pulsen mit spezifischer Anregung in den gewünschten Frequenzbereichen, die in Kombination mit Faltung der Frequenzen der indirekten Dimension, Kreuzsignale beliebig im Frequenzraum zu verlagern.

Figur 1 zeigt schematisch eine Ausführung der SHARC- Sequenz mit einer Reihe von selektiven Pulsen P1, P2, ... bis Pw, die durch eine determinierte Anzahl von inkrementierbaren Wartezeiten (Delays) = {n1, n2, ... nX}, {m1, m2, ..., mY}, ..., {q1, q2, ..., qZ} getrennt sind. Die Anzahl {X,Y und Z} der inkrementierbaren Wartezeiten (Delays) und die Anzahl der anzuwendenden selektiven Pulse W (und somit die Frequenzbereiche $O_i$, $O_{i+1}$ etc.) können beliebig gewählt werden. Der Zahlenbereich, der für W angegeben werden kann, hängt davon ab, wie lang die reale Länge eines selektiven

Pulses vom Anwender gewählt wird. Die reale Länge eines selektiven Pulses wiederum hängt selbst von der gewünschten Anregungsbandbreite ab. Je kürzer die Länge eines selektiven Pulses ist, desto mehr selektive Pulse können in der Sequenz eingebaut werden. Dabei ist der T1/T2-Relaxationsmechanismus der limitierende Faktor. Ein bevorzugter Bereich W ist 1 bis 20.

Die T1/T2-Relaxationsdelays (Wartezeit von Scan zu Scan, auch repetition delay genannt, sind im erfindungsgemäßen Verfahren im Gegensatz zu konventionellen HSQC-Verfahren HSQC (Lit.: G. Bodenhausen, D. J. Ruben, Chem. Phys. Lett.) und (L. E. Kay, P. Keifer, T. Saarinen, J. Am. Chem. Soc. (114), 10663-10665, 1992) bis auf 1/4 des konventionellen T1/T2-Relaxationsdelay (in der Regel 2 Sekunden) gekürzt, um eine schnellere Interscan delay zu realisieren. Dies ist unter anderem dadurch zu erklären, dass die totale Länge (in Sekunden) der erfindungsgemäßen Puls-Sequenzen aufgrund der implementierten band-selektiven Pulse (in der Regel in milli-Sekunden Bereich) deutlich länger sind als die Standard Puls-Sequenzen und daher die Wartezeit bis zum nächsten Scan gekürzt werden kann. Als direkte Konsequenz der Reduzierung des T1/T2-Relaxationsdelays wird eine hohe Repetitionsrate (fast scanning mode) realisiert, was wiederum zu einer Verkürzung der Gesamtmesszeit führt (fast-NMR-Methode).

Die Inkrementierungszeit kann konstant sein - dies ist in Fig. 2 und in Fig. 1 für den Fall X=Y=...=Z dargestellt - oder variabel sein (Fig. 1, wobei die Anzahl der Inkremente veränderlich ist, $X \neq Y \neq ... \neq Z$).

Figur 2 zeigt die Realisierung von verschiedenen spektralen Fenstern in der indirekten Dimension als Funktion von spezifischen Frequenzen. Dabei kommt es nach der Anregung der Frequenzen durch die jeweiligen selektiven Pulse und der Generierung der transversalen Magnetisierung zur Evolution der chemischen Verschiebung und der Spin-Spin-Kopplung:

$$[\text{Shape P1}] - [\Delta t1]m - [\text{Shape P2}] - [\Delta t1]n - \ldots\ldots\ldots - [\text{Shape Pw}] - [\Delta t1]q$$

Abhängig vom Zeitpunkt der Anwendung der selektiven Pulse für die jeweiligen Frequenzen innerhalb der spektralen Fenster in der indirekten Dimension SW', SW" etc. entstehen unterschiedliche Evolutionszeiten der chemischen Verschiebung. Bei geeigneter Konzipierung der Sequenz erfahren die Magnetisierungen, die am Anfang der Sequenz in der Transversalen liegen, eine andere chemische Verschiebung (oder Rotation entlang der Z-Achse) als diejenigen Frequenzbereiche, die später in der NMR-Sequenzabfolge diesen selektiven Puls erfahren, wobei am Beispiel von 3 Pulsen gilt:

$$[\text{Shape}]1 = [\Delta t0]m + [\Delta t0]n + [\Delta t0]p$$

$$[\text{Shape}]2 = [\Delta t0]n + [\Delta t0]p$$

$$[\text{Shape}]3 = [\Delta t0]p.$$

Aus den oben beschriebenen Gleichungen 1 bis 6 ist der Zusammenhang zwischen der Inkrementierungszeit $\Delta t1$ = IN0 und dem spektralen Fenster SW1 in der indirekten Dimension ersichtlich:

Gleichung 7: $$SW1 \approx f(Nd0) \text{ und damit}$$
$$SW1 = 1/(Nd0 \times BF1 \times IN0).$$

Somit kann das spektrale Fenster SW1 als eine Funktion von Nd0, der einzigen Variablen in der Gleichung 7 angenommen werden, wobei gilt $\Delta t1$= IN0 = konstant und BF1 = konstant. Im Unterschied dazu wird bei konventionellen, nicht gefalteten NMR-Messungen Nd0 konstant gehalten und IN0 abhängig vom spektralen Fenster variiert.

Dies bedeutet, dass abhängig von der Anzahl der Inkrementierungszeiten $\Delta t1$ alle von einem selektiven Puls getroffenen Frequenzen selektiv ein eindeutiges und von anderen Frequenzen unterscheidbares spektrales Fenster in der indirekten Dimension im multidimensionalen NMR-Spektrum innerhalb eines Scan-Vorganges zugeordnet werden

kann.

Im Gegensatz zur normalen Faltung eines multidimensionalen NMR-Spektrums liegt hier eine frequenzabhängige Faltung (Band selective folding) des resultierenden NMR-Spektrums vor, mit der Konsequenz, dass die Koordinaten der Kreuzsignale nicht mehr an ihrer ursprünglichen chemischen Verschiebung auftreten, sondern abhängig von ihrer Frequenz verschoben, also "gefaltet" sind:

Während eines NMR-Experiments legt die sogenannte dwell-time des analog-to-digital converter (ADC) die maximale Frequenz fest, die innerhalb eines Signals detektiert werden kann. Diese Bedingung ist die oben-genannte Nyquist-Frequenz und entspricht der Hälfte der ‚sampling rate'.

In der t1-Dimension der dwell-time, entspricht Δt1 der festgelegten Dauer, innerhalb der t1 von einem Experiment zum nächsten Experiment mit t2 inkrementiert wird. Man erhält dadurch eine diskrete Matrix F(t1,t2) des Signals F als Funktion von t1 und t2. Typischerweise wird t2 als Reihen von F dargestellt, und t1 als Spalten. Die Fouriertransformation aller Reihen konvertiert diese in Frequenzen, wodurch eine Matrix F(t1,v2) erhalten wird, und nach Fourier-Transformation aller Spalten das finale zweidimensionale Spektrum F(v1,v2). Der spektrale Bereich in der Dimension v1 entspricht nach dem Nyquist-Theorem der dwell-Zeit (dwell-time):

$$v1(max) = 1 /(2 * \Delta t1)$$

Entsprechendes gilt für den spektralen Bereich in der Dimension v2.

In konventionellen NMR-Spektren ist die Nyquist-Bedingung erfüllt. Enthält das Signal aber höhere Frequenzen als durch die Bedingung festgelegt, erscheinen Kreuzsignale im Spektrum in einer scheinbaren Position, die nicht der Position im nicht-gefalteten Spektrum entspricht. Man spricht in diesem Fall von Faltung ("Multidimensional NMR in liquids, Basic Principles and Experimental Methods", F.J.M. van de Ven, VCH: Kapitel 1, Seite 21-23, und Kapitel 4, Two-Dimensional NMR, Seite 163-165).

Mit dem erfindungsgemäßen Verfahren ist es unter anderem möglich, zwei dicht beieinander liegende Kreuzsignale, die jedoch mindestens durch einen selektiven Puls getrennt angeregt werden können, unterschiedlich zu falten und damit ihr Erscheinen in einem multidimensionalen NMR-Spektrum zu verändern. Dies hat erhebliche Bedeutung für die Auflösung des NMR-Spektrums und führt zu einer Signalentzerrung und damit Reduzierung der Gesamtmesszeit des NMR-Experimentes

Das erfindungsgemäße Verfahren bietet darüber hinaus die folgenden Variationsmöglichkeiten der Parametrisierung, um die Lage der Kreuzsignale beliebig zu verändern:

1. Die Anzahl und der Typ (beispielsweise Gauß, Rectangular, Sine, BURP) der angewendeten selektiven Pulse kann innerhalb einer Sequenz frei gewählt werden.
2. Bei der Anregung über die gewählten Frequenzbereiche kann die Reihenfolge der angewendeten phasenmodulierten selektiven Pulse frei gewählt werden, um eine optimale Entzerrung der resultierenden Spektren zu erreichen, siehe Fig. 3.
3. Die Anzahl der Inkrementszeiten Δt1 (Delays) innerhalb der angewendeten selektiven Pulse ist frei wählbar, wobei der Grad der Faltung der Kreuzsignale durch die Größe von Δt1 gesteuert wird.
4. Die Dauer der Inkrementierungszeiten Δt1 ist frei wählbar, siehe Fig. 1 n, m, ..., q frei wählbar.

Bei der Anwendung des SHARC-Protokolls werden die durch die selektiven Pulse ausgewählten Frequenzen oder Frequenzbereiche beliebig gewählten spektralen Fenstern in der indirekten Dimension eines multidimensionalen NMR-Spektrums zugeordnet (siehe Fig. 3).

Figur 4.3 zeigt ein konventionelles NMR-Experiment, wobei allen in der t1-Evolutionszeit befindlichen Frequenzen (z.B. $^{13}C$-Verschiebungsachse) das gleiche spektrale Fenster in der indirekten Dimension SW1 zugeordnet wird, beispielsweise einem SW1 von 100 ppm (alle angeregten Frequenzen innerhalb eines Experimentes werden einem konstanten spektralen Fenster (indirect spectral width) zugeordnet).

In Fig. 4.4 werden die innerhalb eines Experiments durch die selektiven Pulse ausgewählten Frequenzen oder Frequenzbereiche (frequency bandwidth) variablen spektralen Fenstern (indirect spectral width) der indirekten Dimension zugeordnet und frequenzabhängig gefaltet, wobei das in Fig. 1 dargestellte allgemeine Verfahren bzw. die in den Figuren Fig. 6 und Fig. 6.1 dargestellten Pulssequenzen angewendet werden.

Die Dimension der NMR-Experimente, z.B. der in Fig. 6 und 6.1 dargestellten Pulssequenzen, ist immer 2. Es existieren also unabhängig von der Anzahl der inkrementierbaren Delays Δt1 nur zwei Dimensionen, nämlich die Dimension der Protonen und die Dimension des z.B. Kohlenstoffs. Die Zuordnung der frei wählbaren indirekten spektralen Fenstern zu den gewünschten Frequenzen oder Frequenzbereichen wird über die Reihenfolge der angewendeten selektiven Pulsen und somit den Grad der Faltung gesteuert.

Das Prinzip des erfindungsgemäßen Verfahrens wird in Fi. 4.1, 4.2 und 4.4 dargestellt: Unterschiedliche spektrale Fenster SW1 werden in der indirekten Dimension beliebig ausgewählten in der Evolutionszeit befindlichen transversalen Magnetisierungen zugeordnet. Die Reihenfolge der Zuordnung von SW1 zu den einzelnen gewählten Frequenzen (transversale Magnetisierungen in der t1-Dimension) kann von Tieffeld nach Hochfeld (Fig. 4.1), von Hochfeld nach Tieffeld (Fig. 4.2) oder in beliebig gewählter Reihenfolge (Fig. 4.4) erfolgen. Bevorzugt ist ein Verfahren, bei dem die Zuordnung beliebig gewählt wird, um eine maximale Signalseparation (Signalentzerrung) zu erreichen.

Für die Aufnahme der Daten eines nicht-gefalteten multidimensionalen NMR-Experiments definiert Gleichung 6 die Lage der Kreuzsignale als Funktion der Inkrementierungszeit $\Delta t1$.

Unter Beachtung des SHARC Protokolls muss im Unterschied zu Gleichung 6 folgender Ausdruck für die Beschreibung der Lage der Kreuzsignale angenommen werden:

Gleichung 8

$$\nu_i(\Omega s) = f\,(N \times \Delta t1)$$

$$\nu_{i+1}(\Omega s) = f\,(M \times \Delta t1)$$

Aufgrund der Komplexität der Spektren zahlreicher organischer Verbindungen kann durch das SHARC Protokoll ein Beitrag zur Reduzierung der Gesamtmesszeit und einer systematischen Vereinfachung der Datenaufnahme und der Interpretation geleistet werden. Denn komplexe Spektren können in zahlreiche kleinere durch selektive Pulse ausgewählte Bereiche und Spektren überführt und diese dann ausgewertet (automatische Auswertungssysteme). Durch die Variation der oben beschriebenen spektralen Parameter wird es möglich sein, multidimensionale Spektren der bestimmten Regionen eines komplexen Spektrums aufzunehmen, wobei gleichzeitig die Lage der Signale der Teilspektren iterativ optimiert werden kann, so dass möglichst der gesamte zur Verfügung stehenden Frequenzraum ausgenutzt wird und dadurch keine hohe digitale Auflösung benötigt wird.

Figur 5 zeigt eine solche Systematisierung der Datenaufnahme. Das SHARC-Protokoll kann beispielsweise im Bereich der automatischen Strukturbestimmung eingesetzt werden, da insgesamt eine Vereinfachung eines komplexen multidimensionalen Spektrums in Teilspektren vorgenommen werden kann.

Das SHARC-Protokoll kann in beliebigen homo- und heteronuklearen multi-dimensionalen NMR-Experimenten (n größer oder gleich 2) wie HSQC, HMBC, COSY, TOCSY, HSQC-TOCSY usw. implementiert werden. Homo- und heteronukleare n-dimensionale NMR-Experimente sind literaturbekannt (beispielsweise in Angew. Chem. 2003, 115, 3293-3301 aufgelistet). Bevorzugt sind 2- und 3-dimensionale NMR-Experimente. Bevorzugt sind ferner Kreuzsignale von einem der folgenden Kerne mit einem gleichen oder verschiedenen Kern: $^{1}H$, $^{13}C$, $^{15}N$, $^{31}P$,

Eine Version der Implementierung des obenvorgestellten SHARC-Konzepts in ein HSQC-Experiment ist Fig. 6 bzw. 6.1 wiedergegeben. Das Experiment wird demnach als SHARC-HSQC bezeichnet. Fig. 6 zeigt eine SHARC-HSQC-Sequenz, wobei zur Vereinfachung nur 3 Frequenzbereiche S, S' und S" durch die selektiven Pulse wiedergegeben sind. Fig. 6.1 zeigt die gleiche Sequenz, wobei die selektiven Pulse übereinander dargestellt sind.

In Fig 6. sind die Band-selektiven Regionen einer indirekten Dimension mit S, S', S" dargestellt, wobei vorzugsweise der sine shaped pulse field gradient 1ms oder 0.5ms betragen. Der folgende Phasenzyklus (phase cycling) wurde verwendet: $\phi 2$ = 1 1 1 1 3 3 3 3, $\phi 3$ = 0 2, $\phi 4$ = 0 0 2 2, $\phi 10$ = 0, $\phi 11$ = 0, $\phi rec$ = 0 2 2 0 2 0 0 2. Die Daten des SHARC-HSQC Experiments wurden im Echo/antiEcho mode gesammelt. Die Phasen $\phi 3$ und $\phi rec$ wurden nach jedem t1 Inkrement um 180 Grad invertiert, um die . Zentralsignale an die Ränder des HSQC-Spektrums zu verlagern. Beispielsweise entspricht der Frequenzbereich S einem chemischen Verschiebungsbereich von 180-100 ppm des Kerns 13C, der Frequenzbereich S' einem chemischen Verschiebungsbereich von 60-40 ppm des Kerns 13C, und der Frequenzbereich S" einem chemischen Verschiebungsbereich von 20-10 ppm des Kerns 13C.

Der INEPT-Teil der Pulssequenz in Fig. 6 erzeugt 2IzSz-Magnetisierungen (sogenannte ZZ-Magnetisierungen), die abhängig von ihrer Frequenz bandselektiv durch die selektiven 90 Grad Pulse (grau-gestrichelte Rechtecke) in die 2IzSy Magnetisierungen transferiert werden, wo chemische Verschiebung der 13C-Kerne (chemical shift labeling in t1 dimension) stattfindet.

Die Breite des spektralen Fensters (spectral width) der indirekten Zeitdimensionen wird durch die Anzahl der $\Delta t1$-Inkremente (Fig. 6: 2d0) definiert. Gemäß der in Figur 6 dargestellte Sequenz werden nur die Wartezeiten "Delay" d0 inkrementiert. Zur Refokussierung der Phasenfehler, erhalten durch die Anwendung der selektiven Pulse, wurden entsprechend der Figur. 6 die nicht inkrementierbare Kompensationsdelays d10 eingeführt, wobei gilt, dass am Anfang des Experimentes d10 gleich d0 zu setzen ist.

Aus Fig. 6 ergibt sich ferner, dass den Magnetisierungen (2IzSz), die durch den ersten band-selektiven 90 Grad Puls in die transversale Magnetisierung (2IzSy) transferiert werden, eine andere $\Delta t1$ Zeit zuzuordnen ist, als derjenigen 2IzSz-Magnetisierungen, die durch den zweiten und den dritten bandselektiven Puls in die transversale Position (2IzSy) gelangen.

Bei dem erfindungsgemäßen Verfahren werden durch die SHARC Pulssequenzen Magnetisierungen entlang der Z-Achse (z.B. 2IzSz, Iz) gespeichert, um diese dann selektiv nacheinander unterschiedlichen indirekten spektralen Fenster mit bestimmten vorher definierten Frequenzbereichen zuzuweisen. Der Frequenzbereich S ist (2IzSy) 3 x 2d0 (Δt1-Zeiten), damit bekommt der Frequenzbereich S das indirekte spektrale Fenster SW zugewiesen. Beispielsweise entspricht der Frequenzbereich S einer chemischen Verschiebung von 20-10 ppm. Ferner ist der Frequenzbereich S' (2IzS'y) 2 x 2d0 (Δt1-Zeiten), damit bekommt der Frequenzbereich S' das indirekte spektrale Fenster SW' zugewiesen (z.B. entspricht der Frequenzbereich S' einer chemischen Verschiebung von 90-35 ppm). Desweiteren ist der Frequenzbereich S" (2IzS"y) 1 x 2d0 (Δt1-Zeiten), damit bekommt der Frequenzbereich S" das indirekte spektrale Fenster SW'' zugewiesen (z.B. entspricht der Frequenzbereich S einer chemischen Verschiebung von 200-100 ppm). Der Zusammenhang zwischen der Anzahl der inkrementierbaren Δt1-Zeiten und dem indirekten spektralen Fenster wird durch die folgende Gleichung definiert:

$$\Delta t1 = [1/(Nd0 \times SW \times BF1)]$$

wobei Nd0 die Anzahl der Inkremente d0 ist.

Die in Figuren 6 bzw. 6.1 und 7 bzw. 7.1 dargestellten Datenaufnahmen mit 3 bandselektiven Pulsen sind lediglich Beispiele für die Anzahl von bandselektiven Pulsen. Die Anzahl n der bandselektiven Pulse ist frei wählbar, beispielsweise ist n gleich 1 bis 20, vorzugsweise 1 bis 10, besonders bevorzugt 1-6.

Fig. 6.1 beschreibt eine Gradienten-unterstützte Phasen-empfindliche Version der erfindungsgemäßen SHARC-Methode, angewendet auf ein HSQC-NMR-Experiment. Die abgebildete SHARC-HSQC Sequenz kann als eine Summe aus N verschiedenen selektiven HSQC's mit jeweils unterschiedlichen spektralen Fenstern in t1 verstanden werden. In den Abbildungen wurden aus Gründen der Übersichtlichkeit nur drei selektive Pulse (und somit drei verschiedene Phasen-modulierte selektive Pulse mit den Phasen ϕ3, ϕ4 etc.) eingezeichnet. Es gibt jedoch keine Einschränkung hinsichtlich der Anzahl der einzusetzenden selektiven Pulse.. Es werden nur die Δt0 delays durch die entsprechenden Δt1-Zeiten inkrementiert. In Fig. 6 bzw. 6.1 wurden die d0's inkrementiert, die d10 blieben konstant.

Eine Version der Implementierung des SHARC Konzeptes in das HMBC-Experiment ist in Fig. 7 und Fig. 7.1 wiedergegeben. Das Experiment kann demnach als SHARC-HMBC bezeichnet werden. Es handelt sich um eine Gradienten-unterstützte Phasenunempfindliche (magnitude mode) Version von SHARC-HMBC: Die abgebildeten SHARC-HMBC Sequenzen können als eine Summe aus N verschiedenen selektiven HMBC's mit jeweils unterschiedlichen spektralen Fenster in ω1 verstanden werden. Hier wurde aus Gründen der Übersichtlichkeit drei selektive Pulse (und somit drei verschiedene Phasen modulierte selektive Pulse mit der Phase ϕ3) eingezeichnet. Es gibt jedoch keine Einschränkung hinsichtlich der Anzahl der einzusetzenden selektiven Pulse. Die Phasenzyklen sind wie folgt angegeben: ϕ5=0 2; ϕ6=0 0 2 2; ϕ12=0 0 0 0 2 2 2 2; ϕrec=0 2 2 0; Frequenz-diskriminierung in ω1 ist durch Phasenmodulation realisiert (phase twisted line shape); $\Delta_2=1/2*{}^1J_{HC}$, $\Delta_6=1/2*{}^nJ_{HC}$ = defocusing delay.

Die in Fig. 6 bis 7.1 eingezeichneten Pulse haben die folgende Bedeutung:

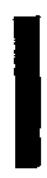

ausgefülltes Rechteck schmal (I) = entspricht 90 Grad hard pulse;

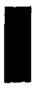

ausgefülltes Rechteck breit (I) = entspricht 180 Grad hard pulse;

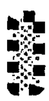

hellgraue Rechteck mit gestricheltem Rand (S, S', S") = entsprechen selektiven 90 Grad Pulsen;

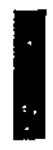

dunkelgraues Rechteck ($G_Z$) = crusher Gradient (Z-Achse) zur Eliminierung von ungewünschten transversalen Magnetisierungen;

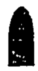

dunkelgraue Halbkegel ($G_Z$) = Gradienten zur Auswahl der gewünschten Magnetisierungen sogenannter Selektionsgradienten.

Das erfindungsgemässe Verfahren zur Datenaufnahme von multidimensionalen NMR-Spektren liefert vorzugsweise innerhalb eines scans abhängig von den ausgewählten Frequenzen unterschiedliche indirekte spektrale Fenster SW1.

Durch das erfindungsgemäße Verfahren werden innerhalb eines Scan unterschiedlich vordefinierte Faltungen in ausgewählten Frequenzbereichen im resultierenden NMR-Spektrum realisiert, wobei mittels frequenzabhängiger Pulse (band-selektive Pulse = Shape pulse) der gewünschte Frequenzbereich ausgewählt wird. Fig. 10.1 zeigt ein konventionelles HSQC-NMR-Spektrum, bei dem Kreuzsignale übereinander erscheinen. Fig. 10.2 verdeutlicht das Ergebnis der Durchführung des Konzeptes der bandselektiven Faltung anhand der Anwendung einer Variante des SHARC-HSQC NMR-Experimentes. Im Vergleich zum Standard HSQC-NMR-Experiment, werden hier innerhalb eines Scan-Vorganges, und gemäss der in Figur 6. bzw. 6.1 dargestellten Pulsfolgen (= Pulssequenzen) vier gewünschte Frequenzregionen variierenden spektralen Fenster in der indirekten Dimension zugeordnet (hier beispielsweise 100 ppm, 5 ppm, 35 ppm, 1 ppm) wodurch das SHARC-HSQC-NMR-Spektrum nach gleichzeitiger Detektion der vier Sub-Spektren in vier indirekte spektrale Fenster (indirect spectral width) S, S', S" und S"' aufgeteilt wird. Die überlagerten indirekten spektralen Fenster S, S', S" und S"' stellen das Ergebnis der Datenaufnahme des SHARC-HSQC-NMR Spektrums dar. Es versteht sich von selbst, dass jedes dieser vier spektralen Fenster S, S', S" und S"' in der indirekten Dimension unterschiedliche Faltungen besitzen kann.

Die vorliegende Patentanmeldung betrifft daher ein Verfahren zur Datenaufnahme multidimensionaler NMR-Spektren mit bandselektiver Faltung, dadurch gekennzeichnet, dass

(1.) n Frequenzbereiche von chemischen Verschiebungen für jeweils eine beliebige Kernsorte, deren Korrelationsspektrum detektiert werden sollen, ausgewählt werden,
(2.) die in Schritt (1.) ausgewählten n Frequenzbereiche der chemischen Verschiebungen durch geeignete selektive Pulse nacheinander angeregt werden, wobei bandselektiv und innerhalb eines Scan-Vorgangs jeweils n gefaltete multi-dimensionale NMR-Spektren pro indirekte Dimension erhalten werden, die sich durch den jeweiligen Grad der Faltung in den indirekten spektralen Fenster SW1 unterscheiden.

Vorzugsweise wird in Schritt (1.) mindestens ein Frequenzbereich enthaltend überlappende Kreuzsignalen ausgewählt.

Zur Auswahl des Frequenzbereiches wird entweder ein multidimensionales NMR-Spektrum aufgenommen, vorzugsweise ein multidimensionales NMR-Spektrum mit niedriger digitaler Auflösung, oder die Frequenzbereiche werden festgelegt, ohne dass ein NMR-Spektrum aufgenommen wird.

Das multidimensionale NMR-Spektrum ist bevorzugt ein homonukleares NMR-Spektrum, ein heteronukleares NMR-Spektrum oder ein Bild-gebendes Verfahren (Imaging Experiment). Das multidimensionale NMR-Spektrum ist ferner vorzugsweise ein 2-dimensionales oder ein 3-dimensionales NMR-Spektrum, besonders bevorzugt ist die Kernsorte 1 H, 13C oder 15N. Beispiele für multidimensionale NMR-Spektren sind HSQC-, HMBC-, HMQC-, COSY-, DOSY-, NOESY-, ROESY-, TOCSY- oder HSQC-TOCSY-Spektren.

In einer bevorzugten Ausführungsform ist die T1/T2-Relaxationszeit, das sogenannte Repetitionsdelay, um den Faktor 4-6, vorzugsweise 5 gekürzt. Beispielsweise wird die T1/T2-Relaxationszeit auf eine Dauer von etwa 400 Millisekunden verkürzt, gegenüber 2 Sekunden, was dem Standardwert der Relaxationszeit in einem konventionellen Spektrum entspricht. Dabei wird eine Beschleunigung der gesamten Messzeit erzielt, wobei die totale experimentelle Messzeit reduziert wird.

Ferner bevorzugt entsprechen in den selektiven Pulsen die Pulsreihenfolge und die inkrementierbaren Wartezeiten der in Figur 1 dargestellten Sequenz, vorzugsweise entsprechen die Pulse der in Figur 6, Figur 6.1, Figur 7 oder Figur 7.1 dargestellten Pulssequenz.

Wird das erfindungsgemäße Verfahren dazu eingesetzt, ein mehr als zweidimensionales NMR-Spektrum aufzunehmen, werden die Schritte (1.) und (2.) für mehr als nur eine Kernsorte gleichzeitig durchgeführt, wobei in mehreren indirekt gemessenen spektralen Fenstern der jeweiligen Kernsorte, beispielsweise 13C oder 15N bandselektive Faltungen erhalten werden.

Eine Rückrechnung der in Schritt (3.) erhaltenen SHARC-HSQC-Daten auf die chemischen Verschiebungen bzw. spektralen Fenster des dazugehörigen Standard-HSQC-Spektrums ist nach Dunn und Sidebottom (Magn. Reson. Chem. 2005, 43, 124-131) oder Takasugi (46th ENC Conference, 10.-15. April 2005, Providence, RI, USA) möglich. Die chemischen Verschiebungen des korrespondierenden nicht-gefalteten multidimensionalen NMR-Spektrums entsprechen den realen Werten, die man erhält, wenn ein nicht-gefaltetetes NMR-Spektrum aufgenommen wird. Diese Signale liegen, wie oben beschrieben, häufig als Cluster, also mit schlechter Auflösung vor.

In einer besonders bevorzugten Ausführung wird das SHARC-Protokoll in einem zweidimensionalen HSQC-NMR-Experiment implementiert, also ein Spektrum, das zwei Frequenzachsen aufweist. Die Intensitäten der dabei entstehenden Kreuzsignale entsprechen der dritten Dimension.

Das erfindungsgemäße Verfahren ermöglicht eine vereinfachte Auswertbarkeit von multidimensionalen NMR-Spektren und eine sehr schnelle Datenaufnahme von NMR-Messungen insbesondere bei gleichzeitig verbesserter Auflösung. Das Verfahren ist anwendbar in der Strukturaufklärung von organischen Verbindungen, beispielsweise Naturstoffen und/oder Peptiden. Das erfindungsgemäße Verfahren kann ferner verwendet werden zur Strukturaufklärung von anorganischen Verbindungen, in der automatischen Strukturbestimmung, der Bio-NMR-Spektroskopie, zum Screening organischer Verbindungen, bei der Analyse komplexer Mineralölfraktionen und in Metabonomics (complex mixtures).

Als ein Beispiel für die Datenaufnahme im Sinne des beschriebenen SHARC Protokolls wurde ein zweidimensionales SHARC-HSQC zur Strukturaufklärung des Naturstoffs Cyclosporin A gemäß Figur 9:

Die SHARC-HSQC Messungen des zyklischen Peptids Cyclosporine A (50mM) [Bruker Standard Probe] gelöst in deuteriertem Benzol $C_6D_6$ (Lock) wurden auf einem Bruker AVANCE 400 Spektrometer mit einer Spektrometerfrequenz von 400,13 MHz (9.39 Tesla) und bei einer Temperatur von 300 K gemessen.
Phasen-sensitive 2D-SHARC-HSQC Messungen wurden mit der Sequenz laut Fig. 6 bzw. 6.1 durchgeführt.

Vor der Durchführung des eigentlichen Experimentes wird optional eine $\pi/2$ (90 Grad) Protonen-Pulskalibrierung durchgeführt, um später einen maximalen Transfer der Magnetisierung zu gewährleisten. Ferner sollte die Leistung der $\pi/2$ selektiven Pulse im Zusammenhang mit der Pulslänge und der sogenannten Anregungsbandbreite entweder direkt an der Probe kalibriert werden oder mit der Spektrometersoftware angenähert berechnet werden. Beide Lösungen zur Kalibrierung der Leistung der $\pi/2$ selektiven Pulse können für das vorliegende Verfahren eingesetzt werden.

Um die Frequenzbereiche für die selektive Anregung in dem eigentlichen SHARC-HSQC-Experiment abzuschätzen, wurde im Vorfeld ein Standard 2D-HSQC mit niedriger digitaler Auflösung aufgenommen. Dies ist nicht unbedingt notwendig für die Durchführung des Experimentes. Es versteht sich von selbst, dass ebenfalls Informationen aus anderen NMR-Spektren e.g. 1D-$^{13}$C-NMR, multiplizitäts-editierte $^{13}$C (DEPT) hilfsweise herangezogen werden können. Es besteht ebenfalls die Möglichkeit, Frequenzbereiche grundsätzlich festzulegen, ohne durch ein KontrollExperiment die Signal-Koordinaten festzulegen. Dies erfordert jedoch die volle Abdeckung der gewünschten Bandbreiten durch selektiven Pulse.

Danach können Frequenzen oder Frequenzbänder mit entsprechenden Kreuzsignalen bestimmt und den Anregungsbereichen der selektiven Pulse zugeordnet werden. Zusätzlich kann dadurch abgeschätzt werden, wie viele selektive Pulse zur Durchführung des SHARC-HSQC Experimentes eingesetzt werden müssen. Es ist anzumerken, dass beim Übergang zu höheren Magnetfeldern um so mehr selektive Pulse innerhalb der Frequenzbereiche eingesetzt werden können und somit ein höherer Grad an Kreuzsignaldispersion über den vorhandenen Frequenzraum erreicht wird. Dies wird anhand der folgenden einfachen Rechnung deutlich: Bei einer Magnetfeldstärke von 9.39 Tesla besitzt das spektrale Fenster von 20 ppm im Protonen-NMR-Spektrum etwa 8 KHz Bandbreite, während die Bandbreite des Protonen-NMR-Spektrums bei einem 900 MHz-Spektrometer beim gleichen spektralen Fenster etwa 18 KHz beträgt. Bei der Annahme eines selektiven Pulses mit einer Anregungsbandbreite von 400 Hz, ist leicht einzusehen, dass etwa doppelt so viele selektiver Pulse bei höherem Feld implementiert werden können.

Bei der Durchführung der unten angegebenen SHARC-HSQC Sequenz und um eine selektive Anregung der Frequenzbereiche in der indirekten Dimension zu erreichen, sind unter anderem phasenmodulierte selektive Pulse (abhängig von aktuellen transmitter offset) zum Einsatz gekommen. Dadurch ist es möglich, bei konstant gehaltenem transmitter offset die jeweiligen Frequenzregionen durch Phasenmodulierte selektive Pulse anzuregen, um die Phasenkohärenz der Frequenz zu erhalten. Als Pulsfolge wurde die Sequenz nach Fig. 6 bzw. 6.1 verwendet.

Das SHARC-HSQC von Cyclosporine A wurde mit 256 komplexen Datenpunkten in t1 und mit 2K Datenpunkten in t2 aufgenommen. Es wurden pro Datenpunkt jeweils 8 Transienten aufgenommen. Die spektrale Weite in t2 betrug

8250 Hz. Während der Signaldetektion in t2 wurde zwecks heteronuklearer Entkopplung eine GARP Sequenz mit einer Feldstärke von 3333 Hz angewendet. Nach Zero-Filling, Linear prediction und Fourier-Transformation wurde eine 2K X 512 Datenmatrix erhalten. Der Relaxationsdelay betrug 2 Sekunden. Zur Unterscheidung der Vorzeichen der Frequenzen in der indirekten Dimension und damit einhergehenden Phasenempfindlichkeit des 2D-SHARC-HSQC-Spektrums, wurde ein Gradient Echo/Antiecho Verfahren eingesetzt, wobei nach jedem t1-Inkrement die Phase der selektiven $\pi/2$ Pulse und die Phase des Receivers um $\pi$ invertiert wurden.

Wie bereits in der Beschreibung des 2D-NMR-Spektroskopie angedeutet, wird nun nach jedem t1-Inkrement die Variable $\Delta$t0 (hier in der Zeichnung d0) um $\Delta$t1 inkrementiert. Dabei erfahren die Frequenzen in der indirekten Dimension (hier Kohlenstoff), je nachdem, zu welchem Zeitpunkt sie von den einzelnen selektiven Pulsen getroffen worden sind, unterschiedliche Rotationen um den chemischen Verschiebungsvektor.

Anhand der Pulssequenz, wie in Fig. 6 und 6.1 verdeutlicht, wurde zwecks der heteronuklearen Entkopplung in der t1-Evolutionszeiten geeignete $\pi$-Pulse im Protonenkanal eingesetzt. Die $\pi$-Pulse sind symmetrisch innerhalb von $\Delta$t0 bzw. n x $\Delta$t0 und nach jedem selektiven Puls im Kohlenstoffkanal eingesetzt.

Während der t1-Evolutionszeit kommt es aufgrund der Anwendung der jeweiligen selektiven Pulse, die mehrere Millisekunden lang sein können, zur Akkumulation von sogenannten Phasenfehlern (phase error), die kompensiert werden müssen. Daher refokussiert in der Mitte der t1-Evolutionszeiten ein sogenannter $\pi$-Hard Puls im Kohlenstoffkanal alle vorangegangenen chemischen Verschiebungen in der Weise, dass zu Beginn der Inkrementierung mit $\Delta$t1 keine Phasenfehler mehr vorliegen und somit nach der Aufnahme aller Datenpunkte und der Prozessierung der NMR-Daten keine nachträgliche Phasenkorrektur in der indirekten Dimension vorgenommen werden muss.

Fig. 8 zeigt ein Standard-HSQC von Cyclosporine A (Bruker standard sample).

Fig. 9 zeigt ein SHARC-HSQC, das mit den oben genannten Bedingungen aufgenommen wurde. Deutlich zu erkennen sind die in bisher nicht genutzte Bereiche verlagerte cross peaks.

Folgende Parameter wurden bei der Messung des SHARC-HSQC-NMR von Cyclosporine A eingehalten (Bruker AVANCE 400 Spektrometer Auflistung):

| | | | | | |
|---|---|---|---|---|---|
| PROBHD | 5 mm BBO BB-1H | NUC1 | 1H | GPNAM16 | SINE.100 |
| PULPROG | sapefreqEXC_10 | P1 | 8.80 usec | GPNAM17 | SINE.100 |
| TD | 2048 | p2 | 17.60 usec | GPNAM18 | SINE.100 |
| SOLVENT | DMSO | P29 | 2000000.00 usec | GPNAM19 | SINE.100 |
| NS | 8 | PL1 | -1.50 dB | GPNAM20 | SINE.50 |
| DS | 8 | PL29 | 120.00 dB | GPX16 | 0.00 % |
| SWH | 8250.825 Hz | SFO1 | 400.1316005 MHz | GPX17 | 0.00 % |
| FIDRES | 4.028723 Hz | CPDPRG2 | garp | GPX18 | 0.00 % |
| AQ | 0.1242194 sec | NUC2 | 13C | GPX19 | 0.00 % |
| RG | 12288 | p4 | 19.00 usec | GPX20 | 0.00 % |
| DW | 60.600 usec | P11 | 2000.00 usec | GPY16 | 0.00 % |
| DE | 6.00 usec | PCPD2 | 75.00 usec | GPY17 | 0.00 % |
| TE | 300.0 K | PL0 | 120.00 dB | GPY18 | 0.00 % |
| d0 | 0.00000300 sec | PL2 | 2.00 dB | GPY19 | 0.00 % |
| d6 | 0.00000070 sec | PL12 | 19.95 dB | GPY20 | 0.00 % |
| d10 | 0.00000300 sec | SF02 | 100.6202720 MHz | GPZ16 | 45.00 % |
| d11 | 0.05000000 sec | SP10 | 40.75 dB | GPZ17 | 33.00 % |
| IN0 | 0.00005521 sec | SP11 | 40.75 dB | GPZ18 | 40.00 % |
| I3 | 128 | SP12 | 40.75 dB | GPZ19 | 38.00 % |
| P3 | 9.50 usec | SP13 | 40.75 dB | GPZ20 | 40.60 % |
| SPNAM10 | test.2 | SPOFF10 | -5643.00 Hz | SI | 992 |
| SPNAM11 | test.2 | SPOFF11 | -3905.00 Hz | SF | 400.1300000 MHz |

(fortgesetzt)

| | | | | | |
|---|---|---|---|---|---|
| SPNAM12 | test.2 | SPOFF12 | -2144.00 Hz | WDW | QSINE |
| SPNAM13 | test.2 | SPOFF13 | 0.00 Hz | SSB | 2 |
| ND0 | 2 | | | LB | 0.00 Hz |
| TD | 256 | | | GB | 0 |
| SFO1 | 100.6203 MHz | | | PC | 1.00 |
| FIDRES | 35.374687 Hz | | | SI | 512 |
| SW | 90.001 ppm | | | MC2 | echo-antiecho |
| FnMODE | undefined | | | SF | 100.6127690 MHz |
| | | | | WDW | QSINE |
| | | | | SSB | 2 |
| | | | | LB | 0.00 Hz |
| | | | | GB | 0 |

**Patentansprüche**

1. Verfahren zur Datenaufnahme multidimensionaler NMR-Spektren mit bandselektiver Faltung, **dadurch gekennzeichnet, dass**

   (1.) n Frequenzbereiche von chemischen Verschiebungen für jeweils eine beliebige Kernsorte, deren Korrelationsspektrum detektiert werden soll, ausgewählt werden,
   (2.) die in Schritt (1.) ausgewählten n Frequenzbereiche der chemischen Verschiebungen durch dem jeweiligen Frequenzbereich entsprechende, selektive 90°-Pulse nacheinander angeregt werden, und die n angeregten Frequenzbereiche jeweils unterschiedliche Evolutionszeiten erfahren, und wobei nach Fouriertransformation in Superposition bandselektiv und innerhalb eines Scan-Vorgangs jeweils n pro indirekte Dimension gefaltete multi-dimensionale NMR-Spektren erhalten werden, die sich durch den jeweiligen Grad der Faltung in indirekten spektralen Fenstern SW1, die der jeweiligen Evolutionszeit entsprechen, unterscheiden.

2. Verfahren nach Anspruch 1, wobei in Schritt (1.) mindestens ein Frequenzbereich enthaltend überlappende Kreuzsignale ausgewählt wird.

3. Verfahren nach einem der Ansprüche 1 oder 2, wobei in Schritt (1.) zur Auswahl eines Frequenzbereiches ein multidimensionales NMR-Spektrum aufgenommen wird, vorzugsweise ein multidimensionales NMR-Spektrum mit im Vergleich zu Schritt (2.) niedriger digitaler Auflösung.

4. Verfahren nach einem der Ansprüche 1 oder 2, wobei in Schritt (1.) Frequenzbereiche festgelegt werden, ohne dass ein NMR-Spektrum mit im Vergleich zu Schritt (2.) niedriger digitaler Auflösung aufgenommen wird.

5. Verfahren nach einem der Ansprüche 1 bis 4, wobei das multidimensionale NMR-Spektrum ein homonukleares NMR-Spektrum, ein heteronukleares NMR-Spektrum oder ein Bild-gebendes Verfahren ist.

6. Verfahren nach einem der Ansprüche 1 bis 5, wobei das multidimensionale NMR-Spektrum ein 2-dimensionale oder ein 3-dimensionales NMR-Spektrum ist.

7. Verfahren nach einem der Ansprüche 1 bis 6, wobei die Kernsorte 1 H, 13C oder 15N ist.

8. Verfahren nach einem der Ansprüche 1 bis 7, wobei das multidimensionale NMR-Spektrum ein HSQC-, HMBC-, HMBC-. COSY-, DOSY-, NOESY-, ROESY-, TOCSY- oder HSQC-TOCSY-Spektrum ist.

9. Verfahren nach einem der Ansprüche,1 bis 8, wobei die Wartezeit von Scan zu Scan auf 0.5s bis 2s gekürzt ist.

**10.** Verfahren nach einem der Ansprüche 1 bis 9, wobei die Schritte (1.) und (2.) für mehr als nur eine Kernsorte gleichzeitig durchgeführt werden, wobei in mehreren indirekt gemessenen spektralen Fenstern der jeweiligen Kernsorte bandselektive Faltungen erhalten werden.

**11.** Verfahren nach einem der Ansprüche 1 bis 10, wobei in einem Schritt (3.) aus den Koordinaten der Kreuzsignale der n gefalteten indirekten spektralen Fenster auf die chemischen Verschiebungen des korrespondierenden nichtgefalteten multidimensionalen NMR-Spektrums zurückgerechnet wird.

**12.** Verwendung eines Verfahrens nach einem der Ansprüche 1 bis 11 zur Vereinfachung der Auswertung von multidimensionalen NMR-Spektren.

**13.** Verwendung eines Verfahrens nach einem der Ansprüche 1 bis 11 zur Strukturaufklärung von anorganischen und organischen Verbindungen, zur Strukturaufklärung von Naturstoffen und/oder Peptiden, in der automatischen Strukturbestimmung, in der Bio-NMR-Spektroskopie, zum Screening organischer Verbindungen, bei der Analyse komplexer Mineralölfraktionen und in Metabonomics.

## Claims

**1.** Method for data acquisition of multi-dimensional NMR spectra with band-selective folding, **characterized in that**

(1.) n frequency ranges of chemical shifts are selected for each arbitrary nuclear species whose correlation spectrum shall be detected,
(2.) the n frequency ranges selected in step (1.) of the chemical shifts are successively excited by selective 90° pulses corresponding to the respective frequency range, and the n excited frequency ranges experience different evolution times each, and wherein after Fourier transformation in superposition n folded multi-dimensional NMR spectra are obtained each per indirect dimension in a band-selective fashion and within one scanning process, which differ with respect to the respective degree of folding in indirect spectral windows SW1 which correspond to the respective evolution time.

**2.** Method according to claim 1, wherein in step (1.) at least one frequency range is selected that contains overlapping cross signals.

**3.** Method according to any one of the claims 1 or 2, wherein in step (1.) a multi-dimensional NMR spectrum is acquired for selecting a frequency range, preferably a multi-dimensional NMR spectrum with low digital resolution compared to step (2.).

**4.** Method according to any one of the claims 1 or 2, wherein in step (1.) frequency ranges are determined without acquiring an NMR spectrum with low digital resolution compared to step (2.).

**5.** Method according to any one of the claims 1 through 4, wherein the multi-dimensional NMR spectrum is a homonuclear NMR spectrum, a heteronuclear NMR spectrum or an imaging method.

**6.** Method according to any one of the claims 1 through 5, wherein the multi-dimensional NMR spectrum is a 2-dimensional or a 3-dimensional NMR spectrum.

**7.** Method according to any one of the claims 1 through 6, wherein the nuclear species is 1H, 13C or 15N.

**8.** Method according to any one of the claims 1 through 7, wherein the multi-dimensional NMR spectrum is a HSQC, HMBC, HMQC, COSY, DOSY, NOESY, ROESY, TOCSY or HSQC-TOCSY spectrum.

**9.** Method according to any one of the claims 1 through 8, wherein the scan-to-scan waiting time is reduced to 0.5 s to 2 s.

**10.** Method according to any one of the claims 1 through 9, wherein the steps (1.) and (2.) are simultaneously performed for more than only one nuclear species wherein band-selective foldings are obtained in several indirectly measured spectral windows of the respective nuclear species.

**11.** Method according to any one of the claims 1 through 10, wherein in a step (3.) the chemical shifts of the corresponding

non-folded multi-dimensional NMR spectrum are calculated from the coordinates of the cross signals of the n folded indirect spectral windows.

**12.** Use of a method according to any one of the claims 1 through 11 for facilitating the evaluation of multi-dimensional NMR spectra.

**13.** Use of a method according to any one of the claims 1 through 11, for analyzing the structure of inorganic and organic compounds, for analyzing the structure of natural substances and/or peptides, for automatic structure determination, for biological NMR spectroscopy, for screening of organic compounds, for the analysis of complex mineral oil fractions, and in metabonomics.

**Revendications**

**1.** Procédé d'acquisition de données de spectres RMN multidimensionnels par convolution sélective en bande, **caractérisé en ce que**

(1.) n gammes de fréquence de déplacements chimiques pour chaque fois un type de noyau quelconque dont le spectre de corrélation doit être détecté sont sélectionnées,
(2.) les n gammes de fréquence de déplacements chimiques sélectionnées à l'étape (1.) sont excitées l'une après l'autre par des impulsions sélectives à 90° correspondantes à la gamme de fréquences respective et les n gammes de fréquences excitées éprouvent chacune des temps d'évolution différents, sachant qu'après transformation de Fourier on obtient en superposition de manière sélective en bande et à l'intérieur d'un processus de balayage chaque fois n spectres RMN multidimensionnels convolués par dimension indirecte, qui diffèrent par le degré respectif de convolution dans des fenêtres spectrales indirectes SW1 qui correspondent au temps d'évolution respectif.

**2.** Procédé selon la revendication 1, dans lequel, à l'étape (1.), au moins une gamme de fréquences contenant des signaux non diagonaux superposés est sélectionnée.

**3.** Procédé selon l'une des revendications 1 ou 2, dans lequel, à l'étape (1.), pour sélectionner une gamme de fréquences, on enregistre un spectre RMN multidimensionnel, de préférence un spectre RMN multidimensionnel avec une résolution numérique inférieure par rapport à l'étape (2.).

**4.** Procédé selon l'une des revendications 1 ou 2, dans lequel, à l'étape (1.), on définit des gammes de fréquences sans enregistrer un spectre RMN avec une résolution numérique inférieure par rapport à l'étape (2.).

**5.** Procédé selon l'une des revendications 1 à 4, dans lequel le spectre RMN multidimensionnel est un spectre RMN homonucléaire, un spectre RMN hétéronucléaire ou un procédé d'imagerie.

**6.** Procédé selon l'une des revendications 1 à 5, dans lequel le spectre RMN multidimensionnel est un spectre RMN bidimensionnel ou tridimensionnel.

**7.** Procédé selon l'une des revendications 1 à 6, dans lequel le type de noyau est 1H, 13C ou 15N.

**8.** Procédé selon l'une des revendications 1 à 7, dans lequel le spectre RMN multidimensionnel est un spectre HSQC, HMBC, HMQC, COSY, DOSY, NOESY, ROESY, TOCSY ou HSQC-TOCSY.

**9.** Procédé selon l'une des revendications 1 à 8, dans lequel le temps d'attente de balayage à balayage est raccourci à 0,5 s à 2 s.

**10.** Procédé selon l'une des revendications 1 à 9, dans lequel les étapes (1.) et (2.) sont exécutées en même temps pour plus d'un type de noyau, des convolutions sélectives en bande étant obtenues dans plusieurs fenêtres spectrales mesurées indirectement du type de noyau respectif.

**11.** Procédé selon l'une des revendications 1 à 10, dans lequel, dans une étape (3.), on remonte à partir des coordonnées des signaux non diagonaux des n fenêtres spectrales indirectes convoluées aux déplacements chimiques du spectre RMN multidimensionnel non convolué correspondant.

**12.** Utilisation d'un procédé selon l'une des revendications 1 à 11 pour simplifier l'évaluation de spectres RMN multidimensionnels.

**13.** Utilisation d'un procédé selon l'une des revendications 1 à 11 pour élucider la structure de composés anorganiques et organiques, pour élucider la structure de substances naturelles et/ou de peptides, dans la détermination automatique de structures, dans la spectroscopie bio-RMN, pour cribler des composés organiques, dans l'analyse de fractions d'huiles minérales complexes et en métabonomique.

Fig. 1

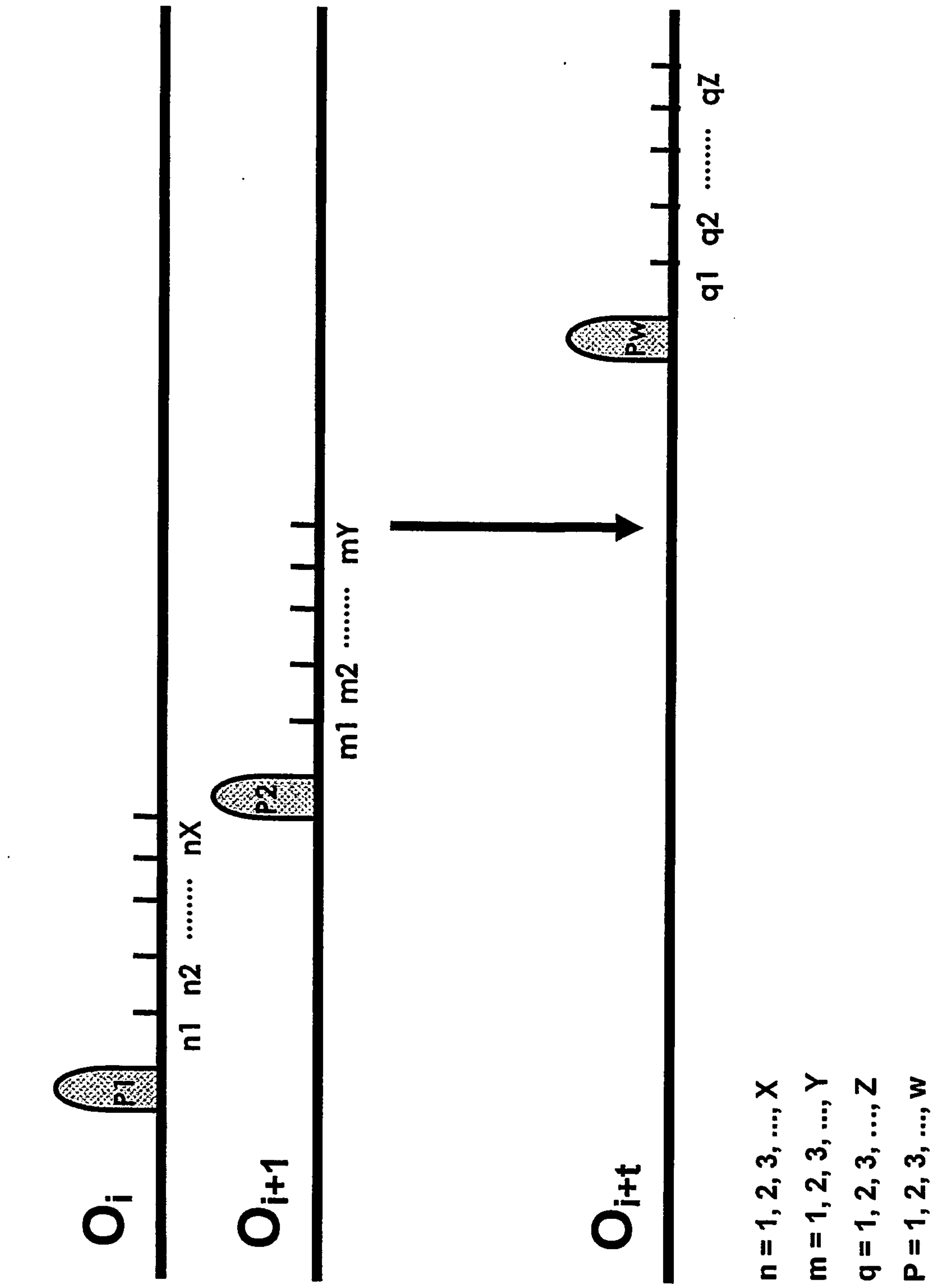
$O_i$
$O_{i+1}$
$O_{i+t}$
P1
P2
PW
n1 n2 ....... nX
m1 m2 ....... mY
q1 q2 ....... qZ
n = 1, 2, 3, ...., X
m = 1, 2, 3, ...., Y
q = 1, 2, 3, ...., Z
P = 1, 2, 3, ...., w

Fig. 2

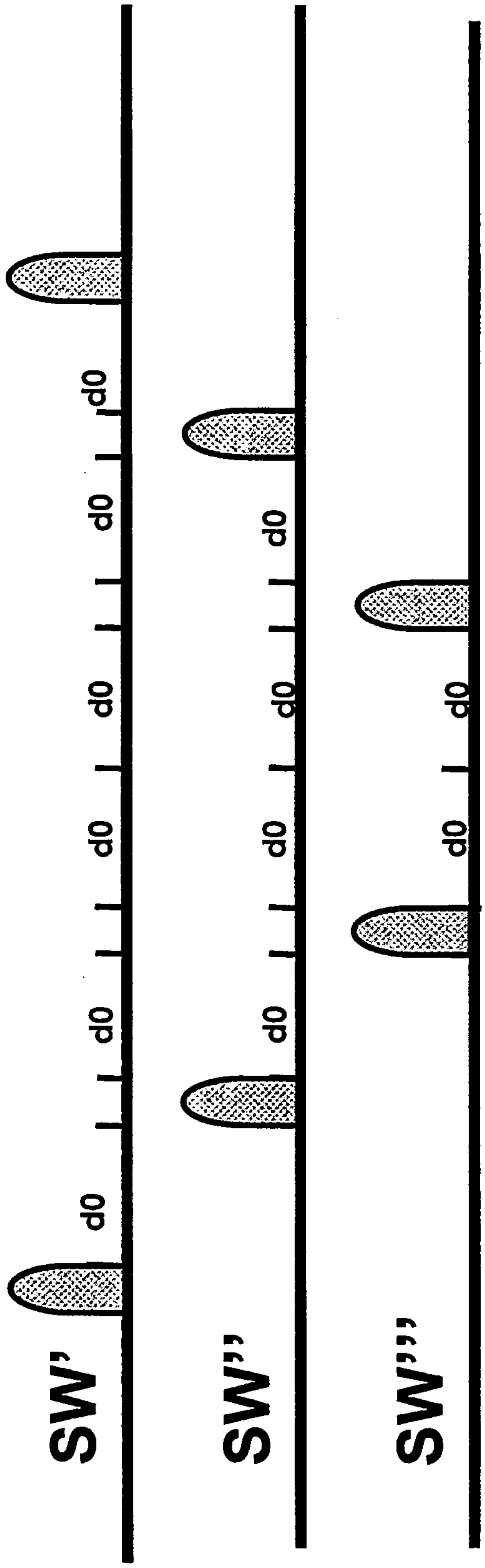

Fig. 3

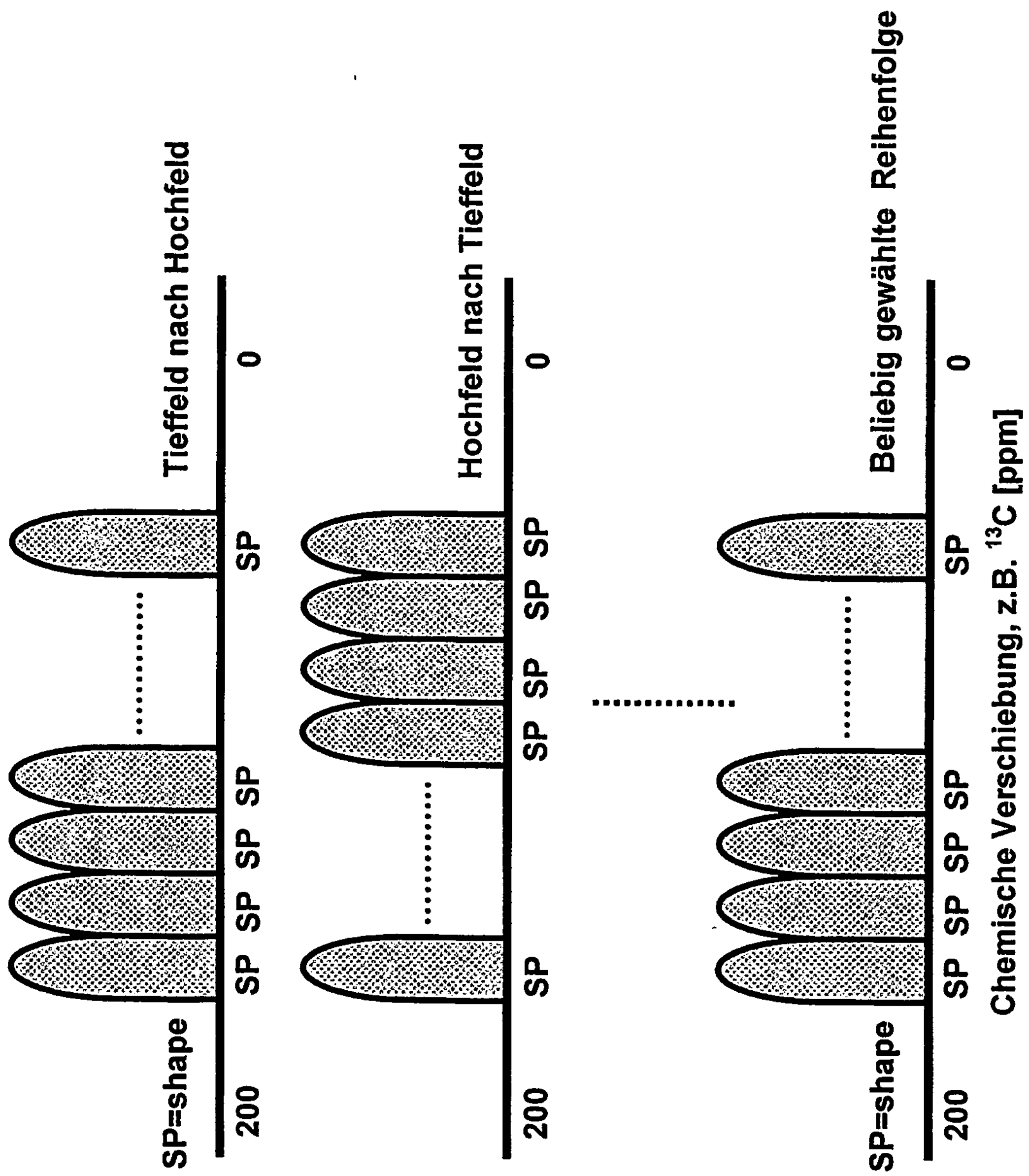
Tieffeld nach Hochfeld
SP=shape
200
SP SP SP SP
SP
0
Hochfeld nach Tieffeld
200
SP
SP SP SP SP
0
Beliebig gewählte Reihenfolge
SP=shape
200
SP SP SP SP
SP
0
Chemische Verschiebung, z.B. 13C [ppm]

Fig. 4

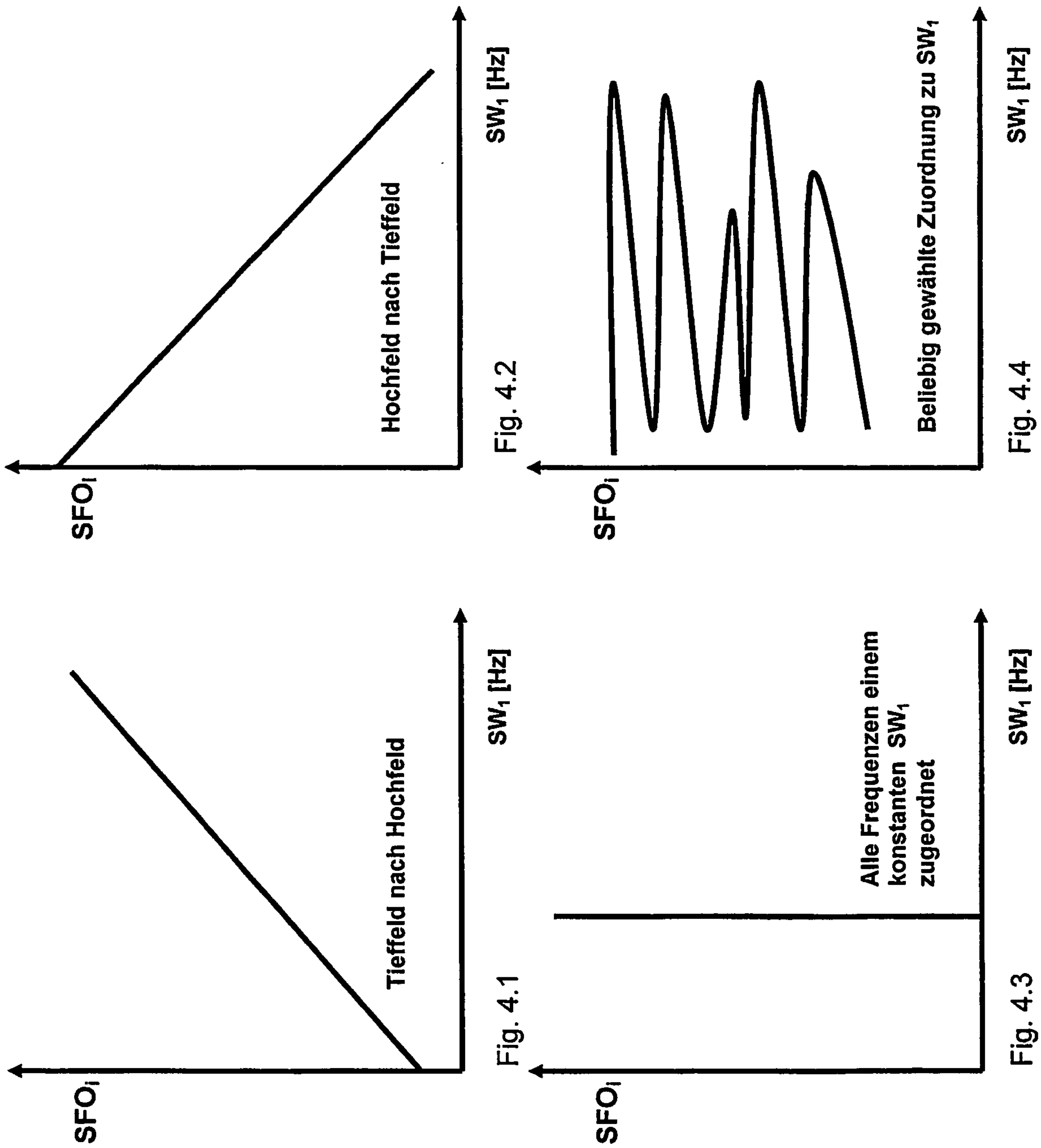
SFO$_i$
SW$_1$ [Hz]
Tieffeld nach Hochfeld
Fig. 4.1
Hochfeld nach Tieffeld
Fig. 4.2
Alle Frequenzen einem konstanten SW$_1$ zugeordnet
Fig. 4.3
Beliebig gewählte Zuordnung zu SW$_1$
Fig. 4.4

Fig. 5

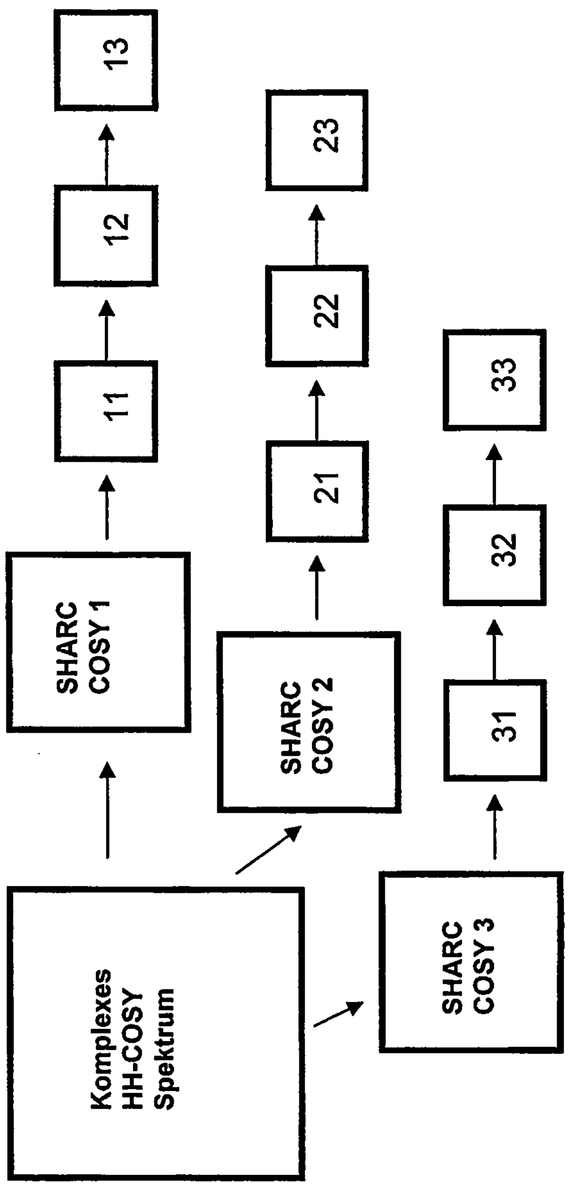
Komplexes
HH-COSY
Spektrum
SHARC
COSY 1
11
12
13
SHARC
COSY 2
21
22
23
SHARC
COSY 3
31
32
33

Fig. 6

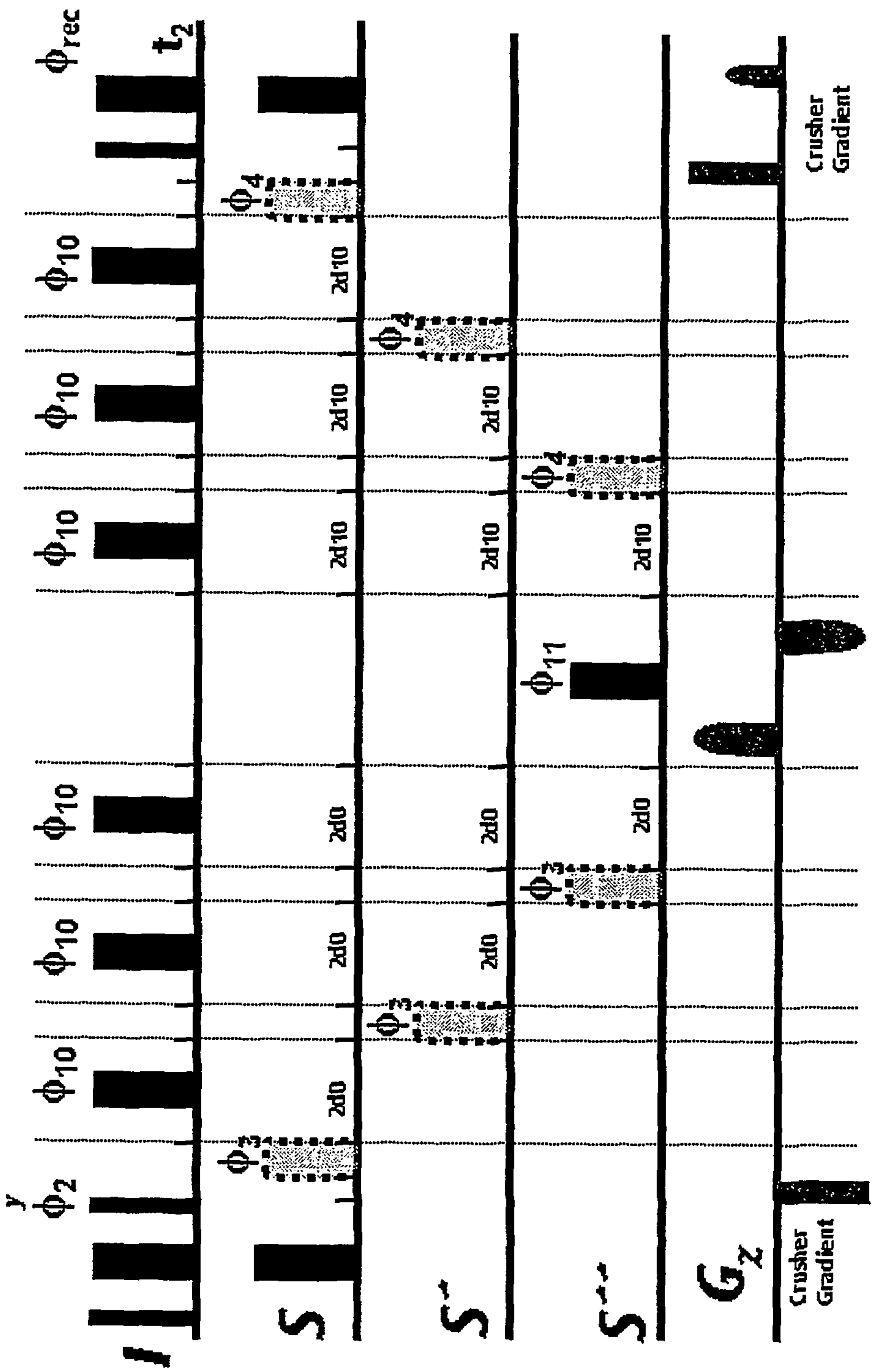

Fig. 6.1

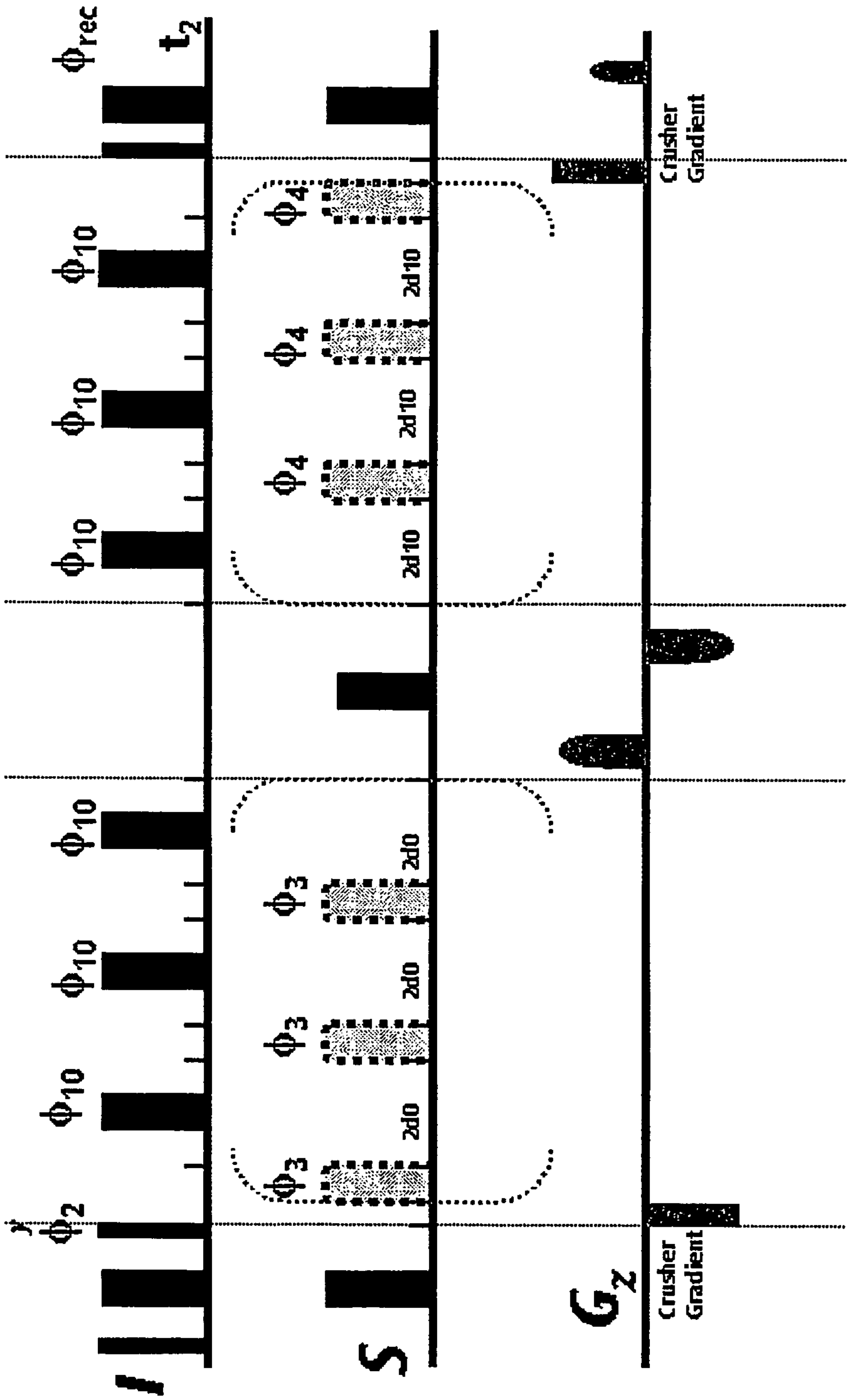
I
S
$G_z$
$t_2$
$\Phi_{rec}$
$\Phi_2$
$\Phi_3$
$\Phi_4$
$\Phi_{10}$
2d0
2d10
Crusher Gradient
Crusher Gradient

Fig. 7

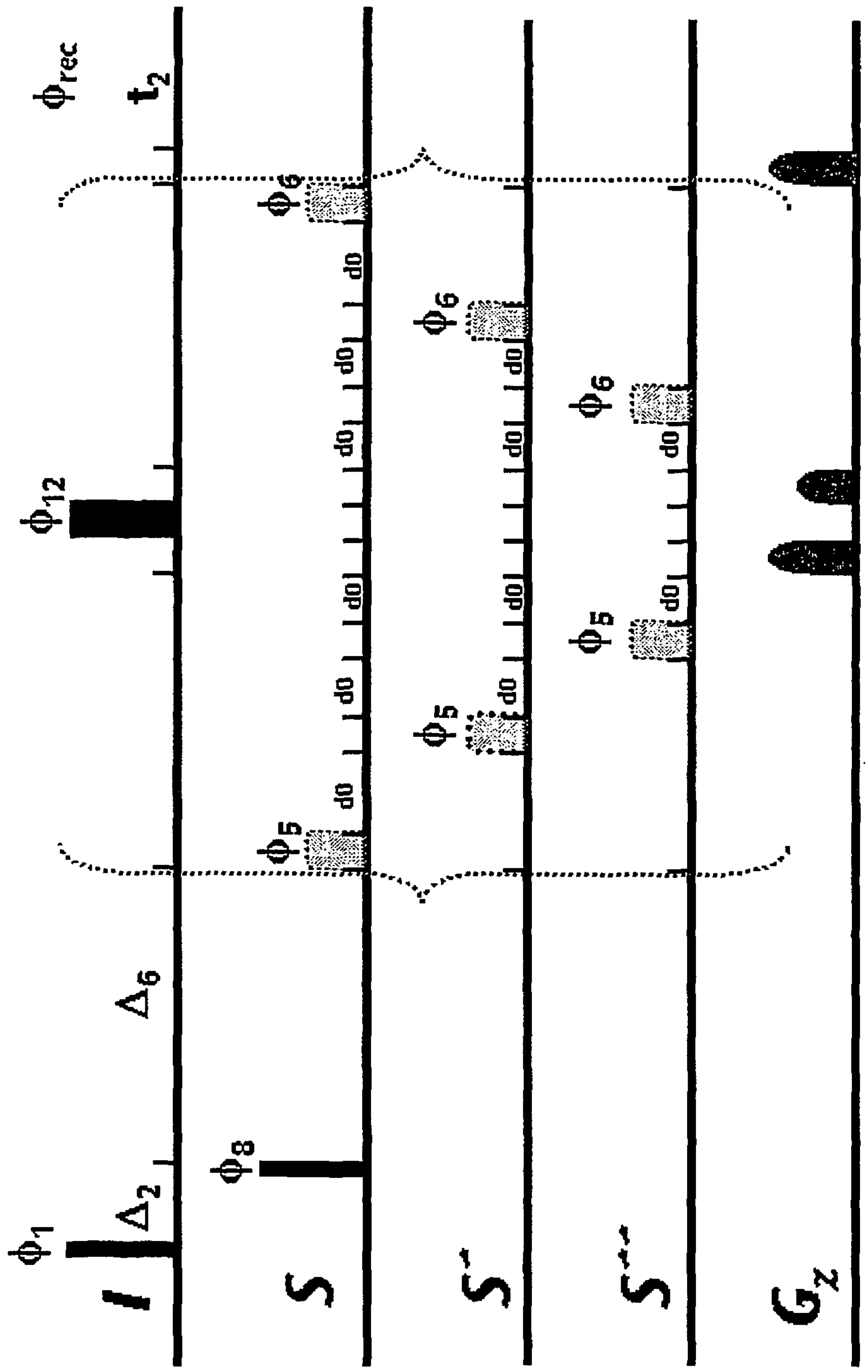

Fig. 7.1

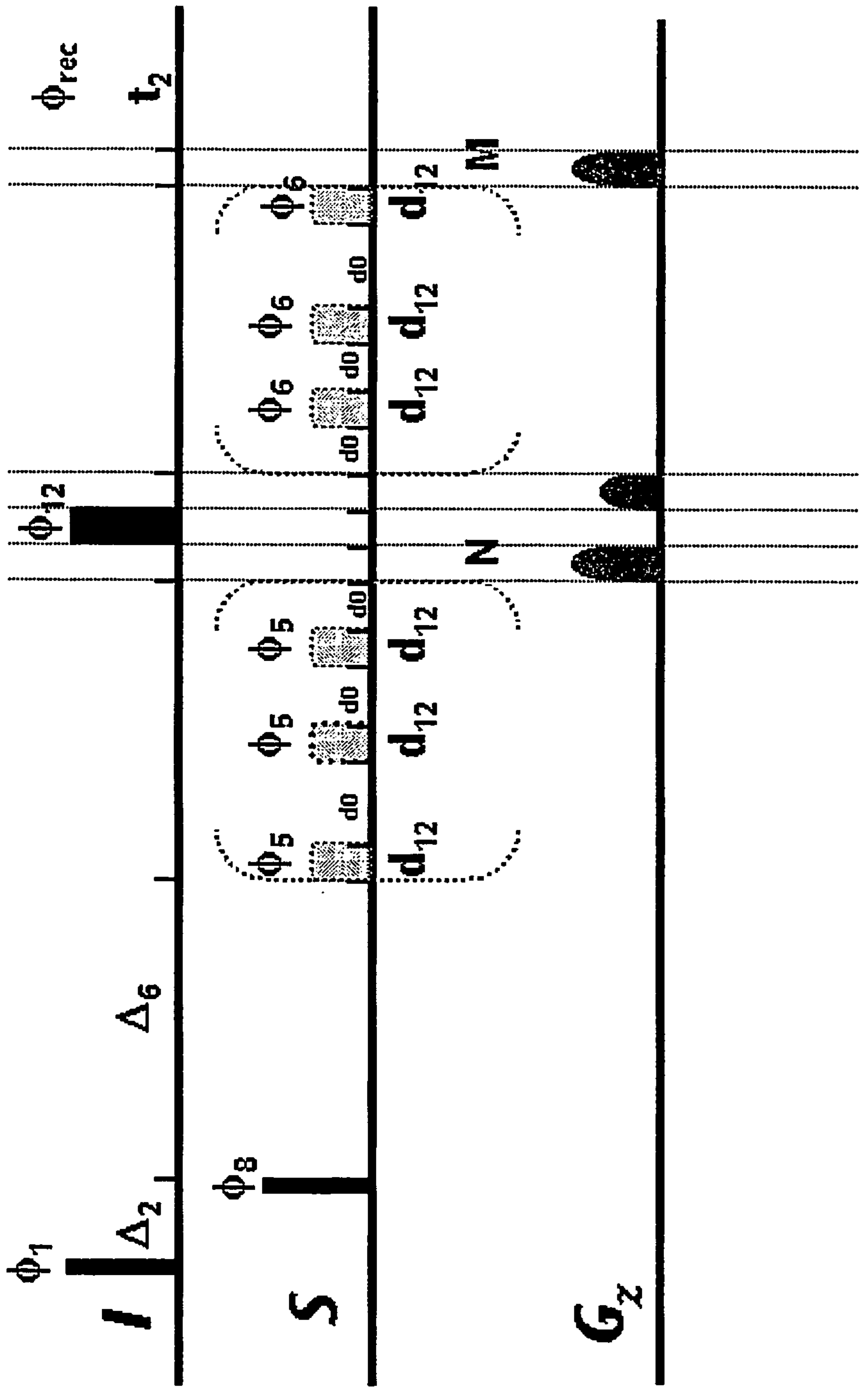

I
S
$G_z$
$\phi_1$
$\Delta_2$
$\phi_8$
$\Delta_6$
$\phi_5$
d0
$d_{12}$
$\phi_{12}$
N
$\phi_6$
M
$\phi_{rec}$
$t_2$

Fig. 8

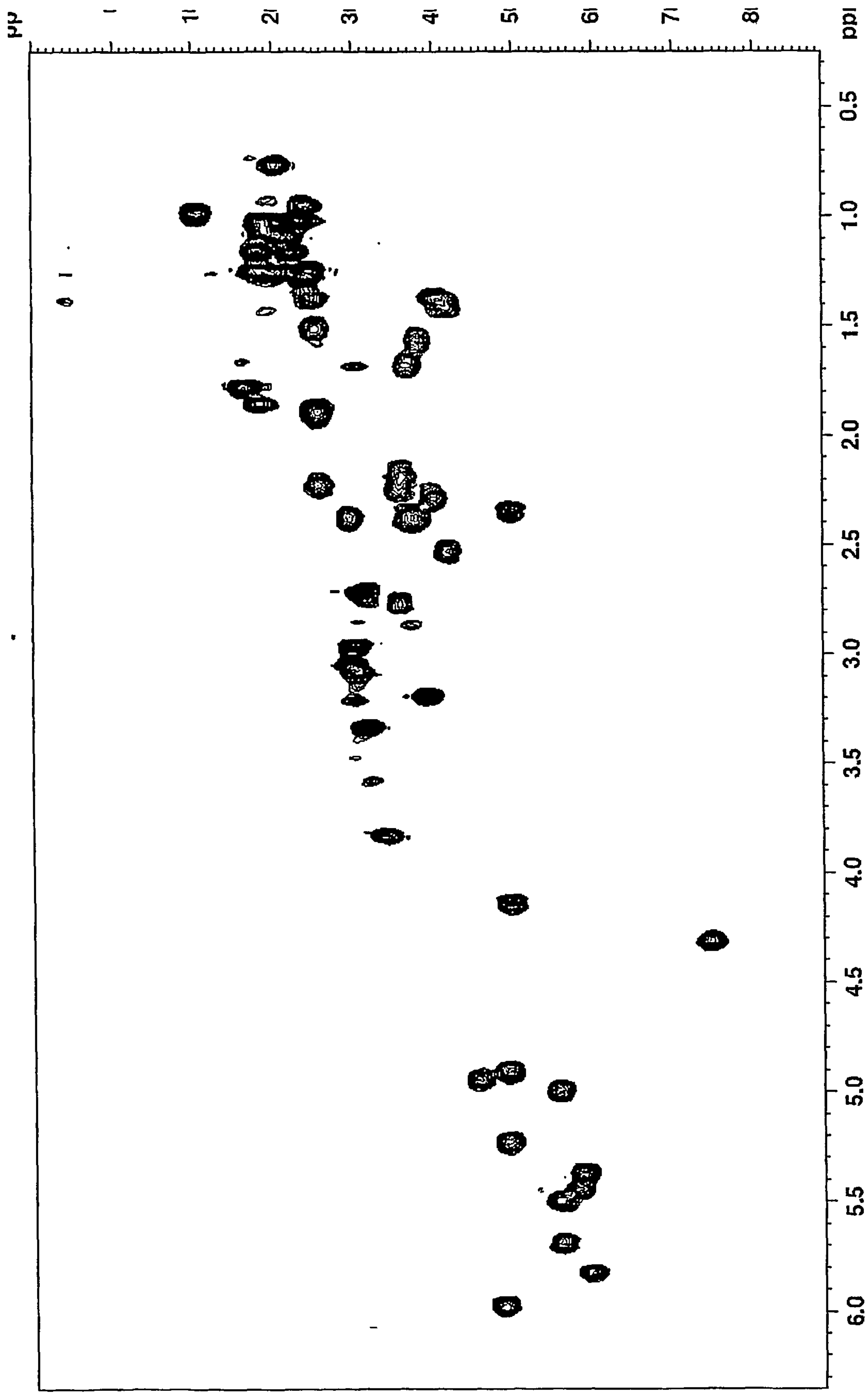

Fig. 9

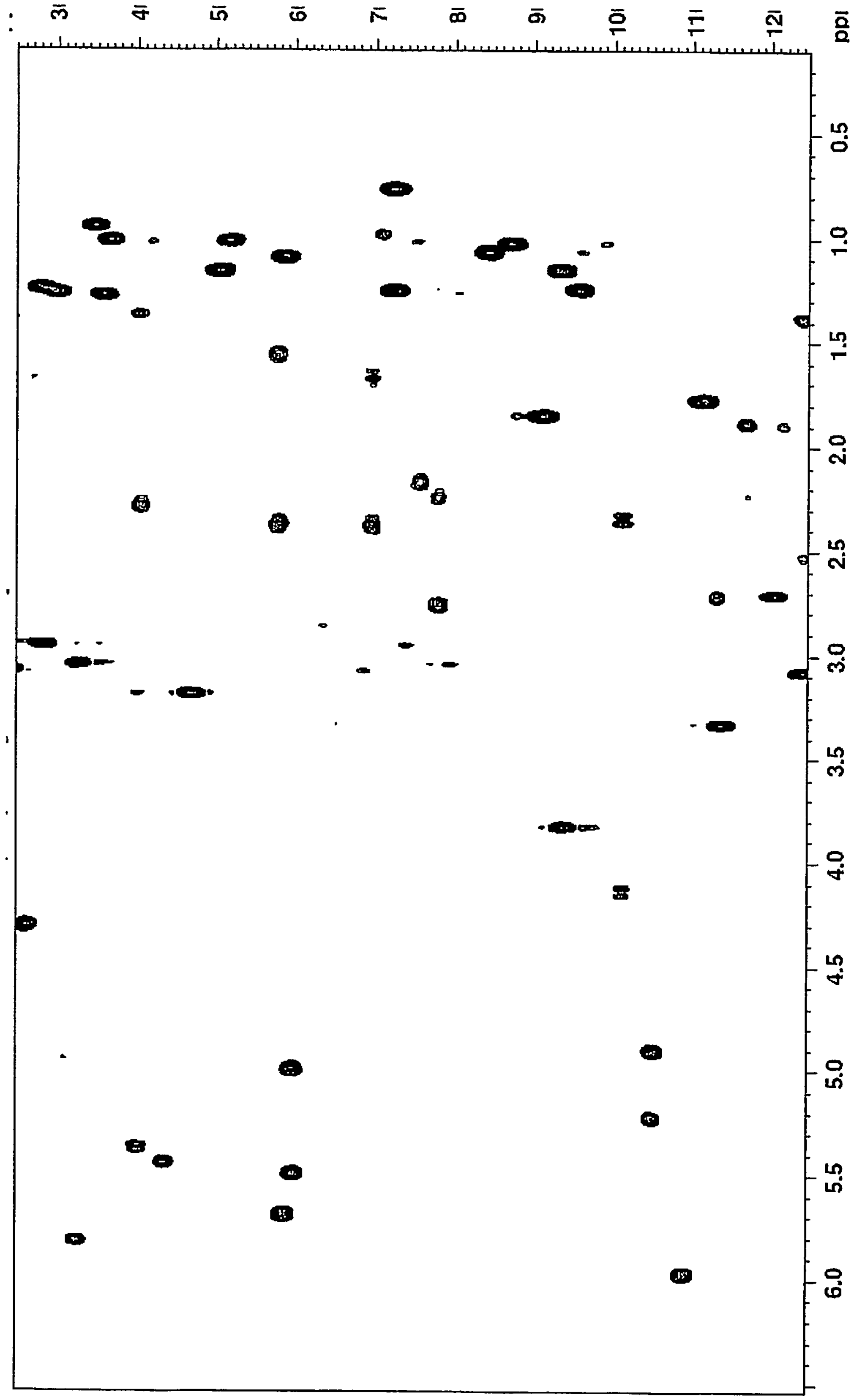

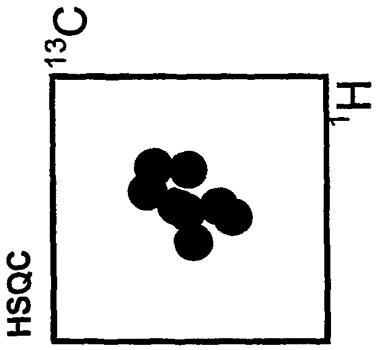


Fig. 10.1

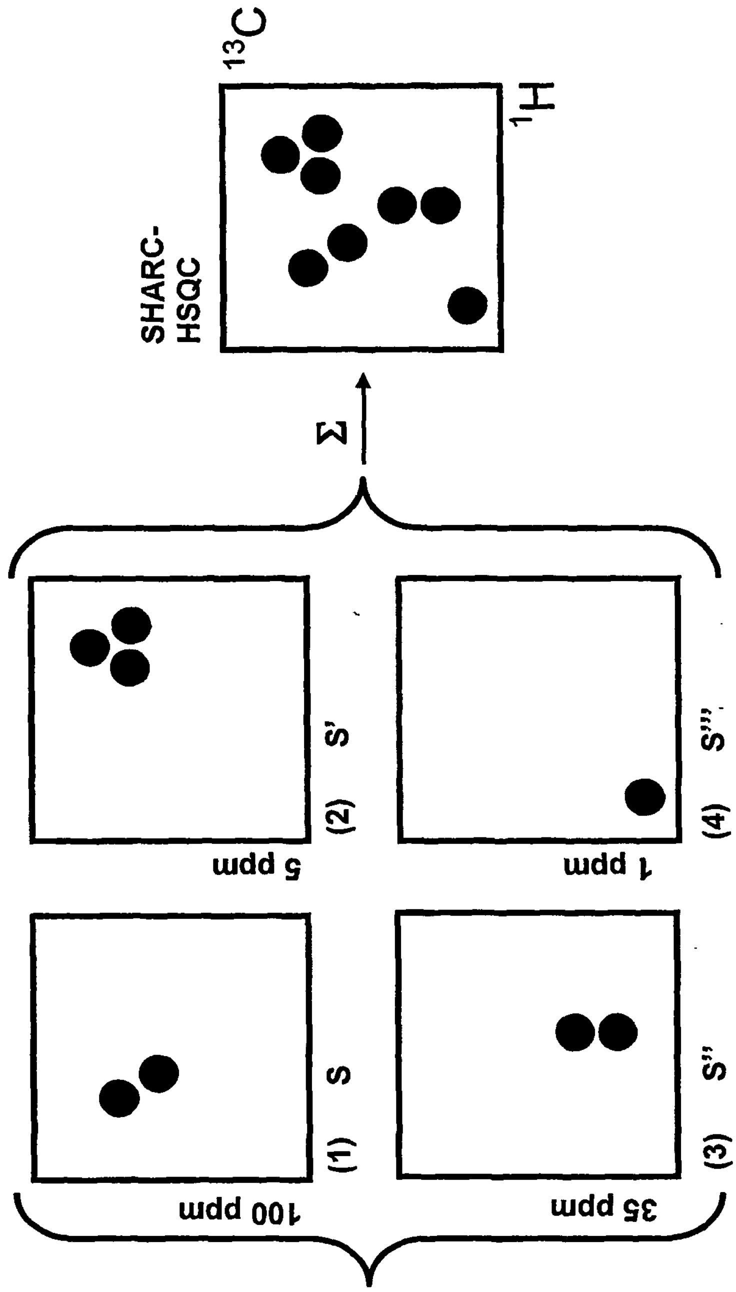


Fig. 10.2

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2004011899 A
- WO 2004007016 A2


### In der Beschreibung aufgeführte Nicht-Patentliteratur


- *Angew. Chem.,* 2003, vol. 115, 3293-3301
- *J. Nat. Prod.,* 2002, vol. 65, 221-244
- *Magn. Reson. Chem.,* 2005, vol. 43, 124-131
- **M. SATTLER.** *Angew. Chem.,* 2004, vol. 116, 800-804
- *J. Am. Chem. Soc.,* 1992, vol. 114, 10663-10665
- **W.R. CROASMUN ; R.M.K. CARLSON.** Two-Dimensional NMR spectroscopy. Wiley-VCH, 1994, 493-503
- **FREEMAN.** *Journal of Progress in Nuclear Magnetic Resonance Spectroscopy,* 1998, vol. 32, 59-106
- **L. E. KAY ; P. KEIFER ; T. SAARINEN.** *J. Am. Chem. Soc.,* 1992, vol. 114, 10663-10665
- **F.J.M. VAN DE VEN.** Multidimensional NMR in liquids, Basic Principles and Experimental Methods. VCH, 21-23
- Two-Dimensional NMR. 163-165
- *Angew. Chem.,* 2003, vol. 115, 3293-3301